# EUROPÄISCHE PATENTSCHRIFT

(11) **EP 4 433 859 B1**
(45) Veröffentlichungstag und Bekanntmachung des Hinweises auf die Patenterteilung: **16.09.2026**
(21) Anmeldenummer: 22818740.7
(22) Anmeldetag: 18.11.2022
(51) Int. Cl.: G02B 26/08, G02B 26/10

(54) **MIKROMECHANISCHES BAUTEIL UND VERFAHREN ZU DESSEN HERSTELLUNG**
MICROMECHANICAL COMPONENT AND METHOD FOR PRODUCING SAME
COMPOSANT MICROMÉCANIQUE ET SON PROCÉDÉ DE FABRICATION

(30) Priorität: 19.11.2021 DE 102021213028
(43) Veröffentlichungstag der Anmeldung: 25.09.2024
(73) Patentinhaber: Fraunhofer-Gesellschaft zur Förderung der angewandten Forschung e.V., 80686 München (DE); OQmented GmbH, 25524 Itzehoe (DE)
(72) Erfinder: SENGER, Frank, 25560 Hadenfeld (DE); MARAUSKA, Stephan, 24568 Kaltenkirchen (DE); HOFMANN, Ulrich, 25524 Itzehoe (DE); WILLE, Gunnar, 25524 Itzehoe (DE); SCHWARZ, Fabian, 25524 Itzehoe (DE)
(74) Vertreter: Pfenning, Meinig & Partner mbB
(86) Internationale Anmeldenummer: PCT/EP2022/082478
(87) Internationale Veröffentlichungsnummer: WO 2023/089127

(56) Entgegenhaltungen:
- US-A1- 2017 366 107
- KAH HOW KOH ET AL: "Investigation of piezoelectric driven MEMS mirrors based on single and double S-shaped PZT actuator for 2-D scanning applications", SENSORS AND ACTUATORS A: PHYSICAL, vol. 184, 1 September 2012 (2012-09-01), NL, pages 149 - 159, XP055480088, ISSN: 0924-4247, DOI: 10.1016/j.sna.2012.06.018
- HONGJIE LEI ET AL: "AlN film based piezoelectric large-aperture MEMS scanning micromirror integrated with angle sensors", JOURNAL OF MICROMECHANICS AND MICROENGINEERING, INSTITUTE OF PHYSICS PUBLISHING, BRISTOL, GB, vol. 28, no. 11, 3 October 2018 (2018-10-03), pages 115012, XP020331610, ISSN: 0960-1317, [retrieved on 20181003], DOI: 10.1088/1361-6439/AAE051
- TAKAYUKI NAONO ET AL: "A large-scan-angle piezoelectric MEMS optical scanner actuated by a Nb-doped PZT thin film", JOURNAL OF MICROMECHANICS AND MICROENGINEERING, INSTITUTE OF PHYSICS PUBLISHING, BRISTOL, GB, vol. 24, no. 1, 9 December 2013 (2013-12-09), pages 15010, XP020255922, ISSN: 0960-1317, [retrieved on 20131209], DOI: 10.1088/0960-1317/24/1/015010

## Beschreibung

Die vorliegende Anmeldung liegt auf dem Gebiet der Mikrosysteme. Die Anmeldung betrifft ein mikromechanisches Bauteil insbesondere einen auf dem Piezoeffekt basierendes MEMS-Bauteil (engl. Micro electro mechanical system, MEMS; dt. mikroelektromechanisches System, kurz Mikrosystem) und ein Verfahren zu dessen Herstellung.

Im Allgemeinen können mikromechanische Bauteile als ein MEMS-Spiegelscanner in Bereichen wie beispielweise Augmented-Reality-Displays, Lichterkennungs- und Entfernungsmessgeräte (LiDAR) oder 3D-Kameras Anwendung finden. Weitere Anwendungen finden sich in Bereichen der Mikropumpen und Energie-Harvester.

Charakteristische Merkmale eines mikromechanischen Bauteiles sind seine kompakte Größe und sein geringer Energiebedarf.

MEMS-Spiegelscanner sind dazu eingerichtet, einen eintreffenden optischen Strahl abzulenken und/oder eine Phasenverschiebung einer korrespondierenden elektromagnetischen Welle hervorzurufen. Eine Ablenkung und/oder Phasenverschiebung der eintreffenden elektromagnetischen Welle kann durch eine Verkippung und/oder eine Drehung eines im MEMS-Spiegelscanner enthaltenden Mikrospiegels verursacht werden. Es existieren verschiedene Methoden zur Ansteuerung eines MEMS-Spiegelscanners, um einen enthaltenden Mikrospiegel zu verkippen und/oder verdrehen. Eine piezoelektrische Ansteuerung, die auf einer Verformung eines piezoelektrischen Körpers basiert, ist vielversprechend, da piezoelektrische Körper sehr genau ansteuerbar sind, effiziente Krafterzeugung durch Umwandlung von elektrischer Energie in mechanische Auslenkung besitzen und somit generell einen geringen Leistungsverbrauch besitzen sowie leicht monolithisch in ein MEMS-Bauteil integriert werden können. Stand der Technik verwandter Art ist beispielsweise in der Druckschrift US 2009 / 185 253 A1 beschrieben.

Die Druckschrift US 2009 / 185 253 A1 beschreibt einen optischen Reflektor, enthaltend einen Spiegel mit einer reflektierenden Ebene; einen Torsionsstab, und einen den Spiegel umgebenden Träger enthält. Für ein piezoelektrisches Element, das eingerichtet ist, eine Torsion hervorzurufen, werden eine erste Elektrodenschicht, eine piezoelektrische Schicht und eine zweite Elektrodenschicht in Reihe auf der oberen Oberfläche eines SOl-Substrats gebildet. Als Material für die erste Elektrodenschicht wird z. B. Ti für eine erste dünne Metallfilmschicht und Pt für eine zweite dünne Metallfilmschicht verwendet. Jede Metallschicht wird durch Sputtern oder eine Elektronenstrahlverdampfungstechnik gebildet. Als nächstes wird auf der ersten Elektrodenschicht die piezoelektrische Schicht gebildet, die beispielsweise aus einem einzigen Film aus einem piezoelektrischen Material besteht. Als Material für die piezoelektrische Schicht kann das piezoelektrische Material Bleizirkonattitanat (PZT) verwendet werden. Die Dicke der piezoelektrischen Schicht beträgt typischerweise 1-10 µm. Die piezoelektrische Schicht wird beispielsweise durch eine Kathodenzerstäubung gebildet.

Die US 8 633 634 B2 beschreibt ein mikromechanisches Bauteil, das als Biegeschwinger ausgebildet ist und als Energie-Harvester dient. Zur Herstellung dieses mikromechanischen Bauteils wird zunächst eine Opferschicht auf ein Siliziumsubstrat aufgebracht, auf die dann ein Schichtaufbau abgeschieden wird, der eine piezoelektrische Schicht und eine darunter liegende, den mechanischen Träger für die piezoelektrische Schicht bildende Funktionsschicht umfasst. Um den Biegebalken, unter anderem bestehend aus Funktionsschicht und piezoelektrischer Schicht, freizustellen, damit er mechanisch beweglich wird, wird die zuvor aufgebrachte Opferschicht aufwendig entfernt. Dabei ist die Empfindlichkeit des piezoelektrischen Materials gegenüber verschiedener physikalischer Prozessgrößen, wie z.B. Temperatur, Säure, Lauge, aber auch Wasserstoff zu berücksichtigen, und es muss eine Reduzierung der durchgeführten Prozessschritte, wie zusätzliche Lithografieebenen sowie Abscheidungen und Ätzungen angestrebt werden.

Weitere MEMS-Bauteile in einem Schichtaufbau mit Piezoelement sind aus KAH HOW KOH ET AL., "Investigation of piezoelectric driven MEMS mirrors based on single and double S-shaped PZT actuator for 2-D scanning applications", SENSORS AND ACTUATORS A: PHYSICAL, Bd. 184, 2012, aus HONGJIE LEI ET AL., "AIN film based piezoelectric large-aperture MEMS scanning micromirror integrated with angle sensors", JOURNAL OF MICROMECHANICS AND MICROENGINEERING, INSTITUTE OF PHYSICS PUBLISHING, BRISTOL, GB, Bd. 28, 2018, aus TAKAYUKI NAONO ET AL: "A large-scan-angle piezoelectric MEMS optical scanner actuated by a Nb-doped PZT thin film", JOURNAL OF MICROMECHANICS AND ICROENGINEERING, INSTITUTE OF PHYSICS PUBLISHING, BRISTOL, GB, Bd. 24, Nr. 1, 2013, und aus US 2017/366107 A1 bekannt.

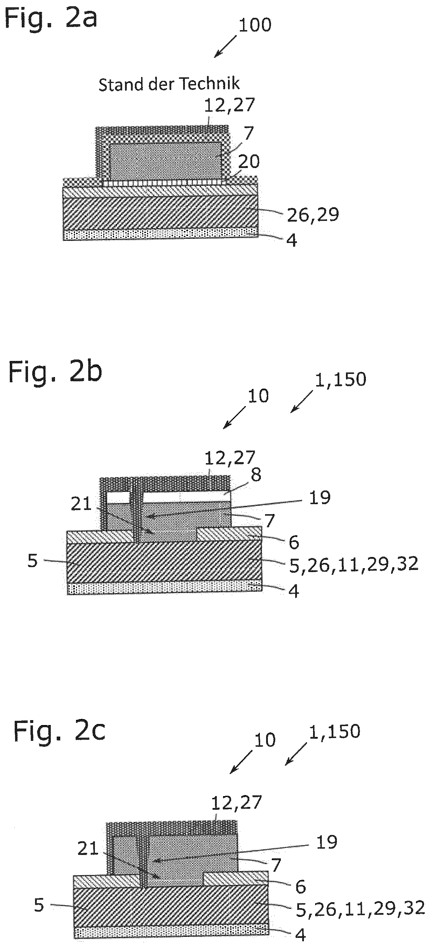

Nachteilig bei vielen aus dem Stand der Technik bekannten mikromechanischen Bauteilen ist, dass eine Vielzahl von Wachstums-, Aufdampf-, Sputter- und Lithographie-Schritte nötig sind, um die einzelnen Bestandteile, wie beispielsweise ein Auslenkungselement, eine Halterung, piezoelektrische Elemente, einschließlich einer ersten und zweiten Elektrode sowie eine mit der Halterung und dem Auslenkungselement mechanisch verbundene Aufhängung zu bilden. Fig. 2a zeigt als eine beispielhafte Ausführungsform eines mikromechanischen Bauteils einen Querschnitt durch einen Teil eines herkömmlichen piezoelektrisch angetriebenen MEMS-Spiegelscanner 100 mit einer metallischen ersten Elektrode 20.

Der vorliegenden Erfindung liegt dementsprechend die Aufgabe zugrunde, ein mikromechanisches Bauteil mit einer reduzierten Herstellungskomplexität vorzuschlagen, das Ressourcen schont und Kosten verringert. Es ist zudem eine Aufgabe, ein entsprechendes vorteilhaftes Verfahren zur Herstellung eines mikromechanischen Bauteils vorzuschlagen, bei dem die Verfahrensschritte vereinfacht sind.

Die Aufgabe wird gelöst durch ein mikromechanisches Bauteil mit den Merkmalen des Anspruchs 1 sowie durch ein Verfahren zur Herstellung eines mikromechanischen Bauteils mit den Merkmalen des unabhängigen Verfahrensanspruchs. Weiterbildungen ergeben sich mit den Merkmalen der abhängigen Ansprüche und der Ausführungsbeispiele.

Das vorgeschlagene mikromechanische Bauteil ist an die unterschiedlichsten Anwendungszwecke anpassbar, beispielsweise ist eine Verwendung als MEMS-Spiegelscanner, Beschleunigungssensor, Energie-Harvester, Drucksensor und dergleichen möglich. Dabei können, wenn gewünscht, große Aktuator- und/oder Sensorflächen realisiert werden und es können breite Bauteilquerschnitte vorgesehen werden, die gegebenenfalls zur besseren Wärmeabfuhr genutzt werden können.

Das mikromechanische Bauteil weist einen Schichtaufbau und mindestens ein piezoelektrischen Element auf, enthaltend eine erste Elektrode und zweite Elektrode zur Erzeugung und/oder Erfassung von Auslenkungen eines Auslenkungselementes. Das Auslenkungselement ist mit einer Halterung verbunden. Der Schichtaufbau umfasst ein Siliziumsubstrat, eine leitfähige Halbleiterschicht, eine piezoelektrischen Schicht und einen leitfähigen Schichtfilm. Die leitfähige Halbleiterschicht bildet die erste Elektrode und der leitfähige Schichtfilm die zweite Elektrode des piezoelektrischen Elementes. Die Halbleiterschicht dient zudem gleichzeitig als eine Trägerschicht für das Auslenkungs-element.

In der Regel wird das mikromechanische Bauteil durch Aufschichten von Metallen, Halbleitern und/oder Isolatoren auf ein Substrat, insbesondere ein Siliziumsubstrat oder ein Silizium-auf-Isolator (engl. silicon on insulator, SOI) Substrat, und durch anschließende Strukturierung zur Ausbildung des Auslenkungselementes, einer Aufhängung, der Halterung und der piezoelektrischen Elemente hergestellt. Wie bereits oben eingeführt, besteht die zweite Elektrode des piezoelektrischen Elementes aus einem Metall und/oder einer Metalllegierungen, insbesondere Al, Cr, Cu, Mo, Ta, Au, Pt oder Ti und die erste Elektrode, die auch die Trägerschicht des Auslenkungselementes ist, aus einem Halbleitermaterial, insbesondere Si.

Dadurch, dass die leitfähige Halbleiterschicht sowohl die erste Elektrode als auch die Trägerschicht des Auslenkungselementes bildet, kann die Komplexität der Herstellung des mikromechanisches Bauteils reduziert werden, da beispielsweise auf zusätzliche Abscheidungs-, Lithographie-, Ätz- und Resistentferungsschritte zur Ausbildung der ersten Elektrode verzichtet werden kann. Halbleitermaterialien können durch ihre kleine Bandlücke sowie die Möglichkeit der Dotierung eine hohe Leitfähigkeit bei Raumtemperatur erreichen, sodass das mikromechanische Bauteil eine niedrige elektrische Betriebsspannung aufweisen kann. Durch hohe Kristallfeldenergien besitzen Halbleitermaterialien zusätzlich eine hohe Steifigkeit und können vorteilhaft als Trägerschichten verwendet werden. Es kann vorhergesehen sein, Halbleitermaterialien wie beispielsweise Si, SiC, AlN, GaN, InN, AlP, GaP, InP, AlAs, GaAs, InAs sowie die zugehörigen ternären Verbindungshalbleiter als erste Elektrode zu verwenden. Für eine hohe Leitfähigkeit kann das Halbleitermaterial n-dotiert, p-dotiert oder intrinsisch sein. Insbesondere kann vorgesehen sein, dass die erste Elektrode aus dotiertem polykristallinem Silizium besteht.

In vorteilhafter Weise ist die Dicke der leifähigen Halbleiterschicht abhängig von vorbestimmten mechanischen und elektrischen Parametern einstellbar und kann an das gewünschte mechanische Verhalten des mikromechanischen Bauteils angepasst werden. Dabei ist es im Vorhinein bei der Herstellung eines bestimmten mikromechanischen Bauteils möglich, anhand der Dicke der leitfähigen Halbleiterschicht das mechanische Verhalten des Bauteils zu bestimmen und festzulegen. Auf der anderen Seite ist es im Nachhinein durch Rückdünnung der leitfähigen Halbleiterschicht am Ende der Prozesskette möglich, die mechanischen Eigenschaften an Anwendungswünsche anzupassen. Durch die Einstellung der Dicke der leitfähigen Halbleiterschicht kann beispielsweise die Resonanzfrequenz eines als MEMS-Spiegelscanner ausgebildeten mikromechanischen Bauteil angepasst oder die Auslenkung eines als Balkenelementes ausgebildeten mikromechanischen Bauteils bestimmt werden.

In weiteren Ausführungsformen können die leitfähige Halbleiterschicht, die piezoelektrische Schicht und der leitfähige Schichtfilm schichtweise in unterschiedlichen Schichtebenen ausgebildet sein, wobei sie eine von einer Seite des Siliziumsubstrates ausgehende Schichtreihenfolge folgender Art aufweisen:
- leitfähige Halbleiterschicht,
- piezoelektrische Schicht,
- leitfähiger Schichtfilm,

Jeweils zwischen den Schichten können weitere Halbleiter, Isolator- und/oder Metallschichten eingefügt sein. Demnach ist ein Abstand der leitfähigen Halbleiterschicht zu dem Siliziumsubstrat, welcher senkrecht zu einer Siliziumsubstratebene gemessen wird, kleiner als ein Abstand zwischen dem Siliziumsubstrat und der piezoelektrischen Schicht, welcher seinerseits kleiner ist als ein Abstand zwischen dem Siliziumsubstrat und dem leitfähigen Schichtfilm. Auf diese Weise kann die piezoelektrische Schicht vorteilhaft mit elektrischer Spannung versorgt werden, um eine piezoelektrische Formänderung der piezoelektrischen Schicht hervorzurufen. Alternativ kann auf diese Weise eine elektrische Spannung, die durch eine Formveränderung der piezoelektrischen Schicht erzeugt wird, effizient abgegriffen oder angelegt werden.

Die piezoelektrische Schicht kann direkt auf der leitfähigen Halbleiterschicht liegen. Weiterhin kann eine Passivierungsschicht zumindest bereichsweise auf der piezoelektrischen Schicht angeordnet sein. Dabei kann der die zweite Elektrode bildende leitfähige Schichtfilm auf der Passivierungsschicht liegen. Es kann gegebenenfalls sinnvoll sein, die zweite Elektrode aus Stabilitätsgründen in einen harten dielektrischen Film einzupacken.

Es kann vorgesehen sein, dass das mikromechanische Bauteil als ein piezoelektrisch angetriebener MEMS-Spiegelscanner ausgebildet ist. Dabei kann das Auslenkungselement eine mit der Halterung verbundene Federstruktur und eine an der Federstruktur aufgehängte Spiegelplatte sein, wobei die leitfähige Halbleiterschicht gleichzeitig die Trägerschicht der Spiegelplatte und/oder der Federstruktur bildet. Die Federstruktur sowie die aufgehängte Spiegelplatte muss zumindest bereichsweise freigelegt werden, um eine vorteilhafte und effiziente Auslenkung zu ermöglichen. Üblicherweise müssen insbesondere bei einer Ausbildung des piezoelektrisch angetriebenen MEMS-Spiegelscanners grundsätzlich eine Vielzahl von Abscheidungsschritten, Lithographieschritten, Ätzschritten und Resistentferungsschritten angewendet werden. Dadurch, dass die leitfähige Halbleiterschicht gleichzeitig die Trägerschicht der Spiegelplatte und/oder der Federstruktur bildet, kann auf diese Weise insbesondere die Komplexität der Herstellung bei einem piezoelektrisch angetriebenen MEMS-Spiegelscanners reduziert werden.

Ferner kann der leitfähige Schichtfilm eine lichtreflektierende Spiegelschicht der Spiegelplatte bilden. Insbesondere eignen sich Metalle oder Metalllegierungen als lichtreflektierende Spiegelschicht der Spiegelplatte, da Metalle einen hohen Reflexionsgrad im sichtbaren und infraroten Spektralbereich (Wellenlängen 400 - 2000 nm) aufweisen. Wiederum kann dadurch eine Anzahl an Herstellungsschritten - insbesondere ein zusätzlicher Abscheidungsprozess - reduziert werden, um die Herstellung des piezoelektrisch angetriebenen MEMS-Spiegelscanners weiter zu vereinfachen. Der Vorteil des Bildens der Spiegelplatte, der Leiterbahn(en) und der Bondpads aus dem abgeschiedenen Schichtfilm aus z.B. Aluminium in einer Dicke von z.B. 400 nm ist jedoch gegen den Nachteil abzuwägen, dass die Spiegelplatte die gleiche Dicke wie die Leiterbahn und die Bondpads aufweist, die wegen der Stabilität und des gewünschten Widerstandswertes eine bestimmte Dicke benötigen. Bei der Spiegelplatte hat diese Dicke einen gewissen Nachteil, da die Rauigkeit, einhergehend mit einer Reduzierung der Reflexion, und auch der Schichtstress zunehmen. Daher ist abzuwägen, ob nach dem Aufbringen der relativ dicken Metallisierung für den leitfähigen Schichtfilm, z.B. 400 nm Aluminium, diese im Bereich der Spiegelplatte wieder entfernt wird und ein weiteres sehr dünnes Metall, z.B. 20 nm Aluminium aufgebracht wird, das dann zeitgleich mit der "dicken" Metallisierung über eine Lackmaske strukturiert werden kann.

Es kann vorgesehen sein, dass die Federstruktur zumindest bereichsweise die leitfähige Halbleiterschicht, die piezoelektrische Schicht und den leitfähigen Schichtfilm aufweist. Die leitfähige Halbleiterschicht, die piezoelektrische Schicht und der leitfähige Schichtfilm bilden das piezoelektrische Element. Unter Verwendung der leitfähigen Halbleiterschicht und des leitfähigen Schichtfilm kann die piezoelektrische Schicht mit elektrischer Spannung versorgt werden, um eine Formänderung aufgrund des piezoelektrischen Effektes hervorzurufen. Dadurch, dass die piezoelektrische Schicht mit der Federstruktur mechanisch verbunden ist, führt eine Formänderung der piezoelektrischen Schicht zu einer Auslenkung der Federstruktur. Diese Auslenkung der Federstruktur führt wiederum zu einer Auslenkung der aufgehängten Spiegelplatte.

In weiteren Ausführungsformen können die leitfähige Halbleiterschicht, die piezoelektrische Schicht und der leitfähige Schichtfilm sich an Positionen mit kleinen Biegeradien bei einer Auslenkung der Federstruktur befinden. In anderen Worten befindet sich das piezoelektrische Element, das gerade aus der leitfähigen Halbleiterschicht, der piezoelektrischen Schicht und dem leitfähigen Schichtfilm gebildet ist, an Positionen auf der Federstruktur mit kleinen Krümmungen unter Betrieb eines Federstruktur-Spiegelplatten-Systems. Bereiche mit großen Biegeradien, die durch eine Simulation, insbesondere eine mechanische Finite-Elemente-Analyse bestimmt werden können, sollten kein piezoelektrisches Element aufweisen, insbesondere um Materialfehlerinduzierte niederohmige Verbindungen aufgrund einer Materialermüdung zu verhindern. Ferner sollten sich die piezoelektrischen Elemente an Positionen mit einem optimalen mechanischen Spannungsverhalten, insbesondere einer hohen positiven mechanischen Spannung oder hohen negativen mechanischen Spannung befinden. Auf diese Weise kann eine Betätigungseffizienz und/oder Erfassungseffizienz maximiert werden. Weiterhin kann die Federstruktur, die die Halterung mit der aufgehängten Spiegelplatte verbindet, mindestens einen gebogenen Bereich aufweisen, der im Ruhezustand insbesondere entlang einer zur Siliziumsubstratebene parallelen Ebene ausgebildet ist.

Ferner kann das Auslenkungselement als ein mindestens einseitig aufgehängtes Balkenelement ausgebildet sein. Die leitfähige Halbleiterschicht bildet dabei gleichzeitig die Trägerschicht des Balkenelements. Das mikromechanische Bauteil kann insbesondere als ein Energie-Harvester ausgebildet sein. Anders als beim piezoelektrisch angetriebenen MEMS-Spiegelscanner ist es vorgesehen sein, dass beim Energie-Harvester die piezoelektrischen Elemente nicht angesteuert werden. Vielmehr wird der Energie-Harvester, insbesondere einschließlich seines Auslenkungselementes mittels Umgebungsvibration in Schwingung, Vibration und/oder Auslenkung versetzt. Eine Empfindlichkeit gegenüber verschiedenen Frequenzspektren der Umgebungsvibration kann mittels einer Geometrie des Energie-Harvesters eingestellt werden. Die Schwingung, Vibration und/oder Auslenkung des Auslenkungselementes wird auf Basis der piezoelektrischen Elemente in elektrische Spannung und/oder einen elektrischen Strom umgewandelt. Diese elektrische Spannung kann nun durch eine geeignete Schaltung gespeichert werden, um sie später zu verwenden. Es kann jedoch auch vorgesehen sein, dass die gewonnene elektrische Spannung sofort über einen Verbraucher verwendet wird. Dadurch, dass die leitfähige Halbleiterschicht gleichzeitig die Trägerschicht des Balkenelements bildet, kann auf diese Weise wiederum die Komplexität der Herstellung reduziert werden.

Weiterhin kann das Balkenelement zumindest bereichsweise die leitfähige Halbleiterschicht, die piezoelektrische Schicht und den leitfähigen Schichtfilm aufweisen. Die leitfähige Halbleiterschicht, die piezoelektrische Schicht und der leitfähige Schichtfilm bilden dabei die piezoelektrischen Elemente. Unter Verwendung der leitfähigen Halbleiterschicht und des leitfähigen Schichtfilms kann die durch die piezoelektrische Schicht gewonnene elektrische Spannung, abgegriffen werden. Dadurch, dass die piezoelektrische Schicht mit dem Balkenelement mechanisch verbunden ist, führt eine Auslenkung des Balkenelementes zu einer Formänderung der piezoelektrischen Schicht. Diese Formänderung führt zu der gewonnenen elektrischen Spannung.

In weiteren Ausführungsformen kann das Balkenelement zumindest bereichsweise das Siliziumsubstrat aufweisen, das derart angeordnet ist, dass es eine Schwungmasse für das Balkenelement bildet. Auf diese Weise kann eine träge Masse des Balkenelementes erhöht werden, um die Umgebungsvibrationen vorteilhaft in eine Schwingung, Vibration und/oder Auslenkung des Balkenelementes umzuwandeln. Insbesondere kann eine Empfindlichkeit gegenüber verschiedenen Frequenzspektren der Umgebungsvibration mittels eines Gewichtes der Schwungmasse eingestellt werden.

Das mikromechanische Bauteil kann zudem zwischen der leitfähigen Halbleiterschicht und der piezoelektrischen Schicht zumindest bereichsweise mindestens eine dielektrische Schicht aufweisen. Die dielektrische Schicht kann als eine Isolator-Schicht ausgebildet sein, die als eine Stromblende für die erste und die zweite Elektrode wirkt. Es kann vorgesehen sein, dass die Isolator-Schicht eingerichtet ist, den Strom an die piezoelektrische Schicht örtlich zu leiten und eine niederohmige Verbindung, insbesondere einen Kurzschluss bei einer Inbetriebnahme des mikromechanischen Bauteiles zwischen der ersten Elektrode und der zweiten Elektrode zu verhindern. Typische Schichtdicken der dielektrischen Schicht liegen zwischen 5 nm und 500 nm, insbesondere zwischen 10 nm und 150 nm. Es kann vorgesehen sein, dass die dielektrische Schicht als eine Passivierungsschicht ausgebildet ist.

In anderen Ausführungsformen kann die leitfähige Halbleiterschicht von der piezoelektrischen Schicht flächendeckend durch eine dielektrische Schicht getrennt sein. Auf diese Weise kann die piezoelektrische Schicht planar auf der dielektrischen Schicht abgeschieden werden. Dadurch werden Nachteile einer Abscheidung der piezoelektrischen Schicht auf eine nicht flächendeckende bzw. eine nicht-planare dielektrische Schicht, die Stufenkanten aufweist, vermieden, die zu Fehlstellen und/oder Kristalldefekten, wie beispielsweise Gruben (engl. pits) und/oder Hohlräume (engl. voids), innerhalb der piezoelektrischen Schicht führen können, wodurch es zu elektrischen niederohmigen Verbindungen und zu einem Kurzschluss des mikromechanische Bauteiles kommen könnte. Insbesondere entstehen die niederohmigen Verbindungen durch ein anschließendes Auffüllen der Gruben und/oder Hohlräume mit weiteren Halbleiter- oder Metallschichten.

In anderen Ausführungsformen kann ein Öffnungsbereich in der dielektrischen Schicht vorgesehen sein. Der Öffnungsbereich ist durch einen direkten Kontakt zwischen der piezoelektrischen Schicht und der leitfähigen Halbleiterschicht gegeben. Dabei ist die Elektrodenfläche der zweiten Elektrode des Öffnungsbereichs kleiner als die Öffnungsfläche des Öffnungsbereichs. Fehlstellen und/oder Kristalldefekte innerhalb der piezoelektrischen Schicht entstehen vermehrt in einem Randbereich des Öffnungsbereiches der dielektrischen Schicht. Die Fehlstellen und/oder Kristalldefekte setzen sich typischerweise in einer zu einer Siliziumsubstratebene senkrechten Richtung fort. Wenn die zweite Elektrodenfläche kleiner ist als die Öffnungsfläche der dielektrischen Schicht ist, liegt die zweite Elektrode nicht direkt über dem Randbereich des Öffnungsbereiches der ersten Elektrode. Auf diese Weise kann ein Eindringen eines Materials der zweiten Elektrode in die Fehlstellen verhindert werden. Das Eindringen des Materials der zweiten Elektrode in die Fehlstelle kann wiederum zu unerwünschten niederohmigen Verbindungen führen.

Es kann vorgesehen sein, dass der Öffnungsbereich der dielektrischen Schicht mit Silizium gefüllt ist. Typischerweise ist eine Schichtdicke der dielektrischen Schicht identisch mit einer Schichtdicke der Siliziumschicht, die für die Füllung verwendeten wird. Hierbei werden durch selektives Wachstum die Öffnungen in der dielektrischen Schicht aufgefüllt. Alternativ zum dem selektiven Wachstum können lithografische Prozesse verwendet werden, um die Füllung des Öffnungsbereich der dielektrischen Schicht zu realisieren. Auf diese Weise kann die piezoelektrische Schicht planar abgeschieden werden. Analog zu oben können Fehlstellen und/oder Kristalldefekten innerhalb der piezoelektrischen Schicht auf diese Weise vermieden werden, die bei einer Abscheidung der piezoelektrischen Schicht auf eine nicht-flächendeckende beziehungsweise nicht-planare Schicht auftreten können. Die Siliziumschicht kann weiterhin dotiert sein, um eine elektrische Leitfähigkeit auf Basis von Akzeptor- oder Donatorzuständen zu erhöhen. Die Öffnungen können mit p-dotiertem, n-dotiertem oder intrinsischem Silizium gefüllt sein. Das Silizium kann insbesondere polykristallin sein. Weiterhin kann die Öffnung der dielektrischen Schicht mit anderen Halbleitermaterialien oder Metallen gefüllt sein. Eine hohe Leitfähigkeit ist hierbei vorteilhaft, um einen Verlust der elektrischen Betriebsspannung zu verhindern.

Eine Schichtdicke der dielektrischen Schicht kann dünner als 2000 nm, insbesondere dünner als 1000 nm und noch bevorzugter dünner als 100 nm sein. Eine dünne dielektrische Schicht führt in dem Öffnungsbereich der dielektrischen Schicht zu einer kleineren Stufenhöhe L zu einer darunterliegenden Schicht. Eine Abscheidung der piezoelektrischen Schicht auf eine quasiflächendeckende bzw. eine quasi-planare dielektrische Schicht kann zu einer reduzierten Dichte an Fehlstellen und/oder Kristalldefekten, innerhalb der piezoelektrischen Schicht führen. In der Regel steigen die Dichte und ein Grad der Ausbildung, insbesondere eine räumliche Ausdehnung, der Fehlstellen mit der Stufenhöhe der dielektrischen Schicht im Öffnungsbereich. Ist die Schichtdicke der dielektrischen Schicht jedoch zu dünn, insbesondere dünner als 10 nm, können Tunnel-, Drift- und/oder Diffusionsströme zu Leckströmen oder Spannungsdurchbrüchen führen. Vorzugsweise sollte die Schichtdicke der dielektrischen Schicht dicker als 1 nm sein.

Weiterhin kann die Schichtdicke der dielektrischen Schicht zu dem Öffnungsbereich hin abnehmen. Auf diese Weise kann ein Gradient einer Stufe und eine maximale Stufenhöhe am Übergang zwischen der dielektrischen Schicht und der piezoelektrischen Schicht reduziert werden, insbesondere bis zu einer Stufenhöhe einer Monolage der dielektrischen Schicht. Eine Abscheidung der piezoelektrischen Schicht auf eine dielektrische Schicht, die zu dem Öffnungsbereich hin abnimmt, kann wiederum zu einer reduzierten Dichte und/oder Grad der Ausbildung an Fehlstellen, innerhalb der piezoelektrischen Schicht führen.

Es kann vorgesehen sein, dass die leitfähige Halbleiterschicht aus Silizium, insbesondere polykristallinem Silizium besteht. In anderen Ausführungen kann die leitfähige Halbleiterschicht aus monokristallinem Silizium ausgebildet sein. Des Weiteren kann die leitfähige Halbleiterschicht dotiert sein. Auf diese Weise kann eine elektrische Leitfähigkeit erhöht werden und eine elektrische Betriebsspannung des mikromechanischen Bauteils gesenkt werden. Durch die Verwendung von polykristallinem Silizium können Kosten für die Fertigung im Vergleich zu monokristallinem Silizium reduziert werden. Andererseits kann eine Verwendung von monokristallinem Silizium eine mechanische Bruchgrenze und somit eine mechanische Robustheit des mikromechanischen Bauteils verbessern.

Ferner kann eine Passivierungsschicht auf der piezoelektrischen Schicht mindestens teilweise angeordnet sein. Die Passivierungsschicht kann isolierend sein. Die Schichtdicke der Passivierungsschicht liegt typischerweise zwischen 5 nm und 500 nm. Es kann vorgesehen sein, dass die Passivierungsschicht bereichsweise nicht parallel zur Siliziumsubstratebene ausgebildet ist und insbesondere Seitenwände - beispielsweise der Gruben oder Hohlräume oder Seitenwände, die durch eine Geometrie des mikromechanischen Bauteils gegeben ist - bedeckt. Auf diese Weise, kann ein galvanischer Kontakt zwischen der ersten und zweiten Elektrode, insbesondere trotz eines Vorhandenseins von Fehlstellen, verhindert werden, der zu niederohmigen Verbindungen führen kann. Eine zu dünne Passivierungsschicht könnte zu Leckströmen auf Basis von Tunnel-, Drift-, Diffusionsströme und/oder Spannungsdurchbrüchen führen. Eine zu dicke Passivierungsschicht kann die Betriebsspannung des mikromechanischen Bauteils stark erhöhen.

In weiteren Ausführungsformen kann zwischen der piezoelektrischen Schicht und dem leitfähigen Schichtfilm, zumindest bereichsweise ein Metallfilm angeordnet sein. Insbesondere ist eine hohe Leitfähigkeit des Metallfilmes vorteilhaft, um eine hohe Betriebsspannung des mikromechanischen Bauteils zu vermeiden. Es kann vorgesehen sein, dass der Metallfilm eingerichtet ist, als eine Maskierungsschicht für einen weiteren Strukturierungsprozess zu dienen. Wird der Metallfilm weggelassen, kann eine Opferschicht als Maskierung für den weiteren Strukturierungsprozess verwendet werden, die anschließend entfernt wird.

Weiterhin kann die Halterung ein Chip-Rahmen des mikromechanischen Bauteils sein. Insbesondere kann es vorgesehen sein, dass der Chip-Rahmen das Auslenkungselement in einer zur Siliziumsubstratebene parallelen Ebene umfasst.

Die vorliegende Anmeldung bezieht sich auch auf ein entsprechendes vorteilhaftes Verfahren. Bei diesem Verfahren zur Herstellung eines mikromechanischen Bauteils wird zunächst eine leitfähige Halbleiterschicht auf einem Siliziumsubstrat abgeschieden. Daraufhin werden eine piezoelektrische Schicht sowie ein als zweite Elektrode dienender leitfähiger Schichtfilm auf die piezoelektrische Schicht abgeschieden. Anschließend wird ein Auslenkungselement durch einen Maskierungsprozess des Siliziumsubstrates, der leitfähigen Halbleiterschicht, der piezoelektrischen Schicht und des leitfähigen Schichtfilms durch lithografische Prozesse strukturiert. Die leitfähige Halbleiterschicht wird dabei als eine erste Elektrode für die piezoelektrische Schicht und gleichzeitig als eine Trägerschicht für das Auslenkungselementes verwendet. Analog zu oben, kann auf diese Weise die Komplexität der Herstellung des mikromechanischen Bauteils reduziert werden, da beispielsweise auf zusätzliche Abscheidungsschritte, Lithographieschritte, Ätzschritte und Resistentferungsschritte zur Ausbildung der ersten Elektrode verzichtet werden kann.

Es kann vorgesehen sein, dass nach dem Abscheiden der piezoelektrischen Schicht ein Abscheiden eines Metallfilms auf die piezoelektrische Schicht folgt. Insbesondere ist eine hohe Leitfähigkeit des Metallfilmes vorteilhaft, um eine hohe Betriebsspannung des mikromechanischen Bauteils zu vermeiden.

Weiterhin kann der Metallfilm als eine Maskierung für einen späteren Strukturierungsprozess, insbesondere einen Strukturierungsprozess der piezoelektrischen Schicht, verwendet werden. Dadurch ist in einfacher Weise ein mikromechanisches Bauteil herstellbar, wobei die empfindliche piezoelektrische Schicht durch Minimieren der Bearbeitungsschritte, wie Ätzschritte, und der Verwendung an Säuren, Laugen und von erhöhten Temperaturen geschont wird. Da keine zusätzlichen Opferschichten bzw. Funktionsschichten benötigt werden, ist keine aufwendige Entfernung der Schichten notwendig und es werden die Herstellungskosten reduziert. Auf diese Weise kann die Komplexität der Herstellung des mikromechanischen Bauteils weiter reduziert werden.

Es kann jedoch auch vorteilhaft sein, auf den Metallfilm zu verzichten. In diesem Fall kann nach dem Abscheiden der piezoelektrischen Schicht eine Hilfs- oder Opferschicht auf die piezoelektrische Schicht abgeschieden werden. Diese Hilfs- oder Opferschicht kann als eine Maskierung für einen späteren Strukturierungsprozess verwendet werden. Insbesondere kann eine SiN Hartmaske als Hilfs- oder Opferschicht vorgesehen sein.

Ferner kann nach dem Abscheiden der piezoelektrischen Schicht eine isolierende Passivierungsschicht auf die piezoelektrische Schicht abgeschieden werden. Die Schichtdicke der Passivierungsschicht liegt typischerweise zwischen 5 nm und 500 nm. Auf diese Weise, kann ein galvanischer Kontakt zwischen der ersten und zweiten Elektrode verhindert werden.

Es kann vorgesehen sein, das Siliziumsubstrat als ein oxidiertes Siliziumsubstrat, insbesondere als ein SOl-Substrat auszubilden. Dadurch kann ein Prozess, insbesondere eine Prozessgenauigkeit und/oder eine Schichtdickengenauigkeit der Trägerschicht und der leitfähigem Halbleiterschicht verbessert werden.

Weiterhin kann der Maskierungsprozess des Substrates eingerichtet sein, dass das Substrat zumindest teilweise in einem Bereich des Auslenkungselementes stehen bleibt. Dadurch lässt sich eine Versteifung des Auslenkungselementes erzielen. Insbesondere kann dies zu einer geringeren Deformation des Auslenkungselementes führen. Verschiedene Strukturen des Siliziumsubstrats, insbesondere wabenartige Strukturen, können vorgesehen sein. Ferner kann eine gesamte Schichtdicke des Auslenkungselementes variiert werden, um insbesondere eine Resonanzfrequenz des mikromechanischen Bauteils damit zu variieren.

Die genannten Merkmale in Bezug auf das mikromechanische Bauteil sind entsprechen auf das Verfahren zur Herstellung des mikromechanischen Bauteils anwendbar.

Ausführungsbeispiele der Erfindung, insbesondere in Form von MEMS-Spiegelscannern und Energie-Harvestern, werden nachfolgend anhand der Figuren erläutert. Dabei zeigen, jeweils schematisch,
- Fig. 1a: eine Draufsicht eines piezoelektrisch angetriebenen MEMS-Spiegelscanners nach einem Ausführungsbeispiel,
- Fig. 1b: einen Querschnitt entsprechend einer gestrichelten Schnittlinie des piezoelektrisch angetriebenen MEMS-Spiegelscanners nach Fig. 1a,
- Fig. 1c: eine Draufsicht eines piezoelektrisch angetriebenen MEMS-Spiegelscanners nach einem weiteren Ausführungsbeispiel mit einem Metallfilm,
- Fig. 1d: einen Querschnitt des piezoelektrisch angetriebenen MEMS-Spiegelscanners nach Fig. 1c,
- Fig. 1e: eine Draufsicht eines Energie-Harvester nach einem Ausführungsbeispiel,
- Fig. 1f: einen Querschnitt entsprechend einer gestrichelten Schnittlinie des Energie-Harvester nach Fig. 1e,
- Fig. 2a: einen Querschnitt eines piezoelektrisch angetriebenen MEMS-Spiegelscanners im Bereich eines piezoelektrischen Elementes mit einer Metallelektrode nach dem Stand der Technik,
- Fig. 2b: einen Querschnitt eines piezoelektrisch angetriebenen MEMS-Spiegelscanners mit einem Metallfilm im Bereich eines piezoelektrischen Elements mit einer Fehlstelle zur Erläuterung von möglichen Fehlern,
- Fig. 2c: einen Querschnitt eines weiteren Ausführungsbeispiels eines piezoelektrisch angetriebenen MEMS-Spiegelscanners ohne einen Metallfilm im Bereich eines piezoelektrischen Elements mit einer Fehlstelle zur Erläuterung von möglichen Fehlern,
- Fig. 3a: eine Draufsicht auf eine Federstruktur eines piezoelektrisch angetriebenen MEMS-Spiegelscanners eines Ausführungsbeispiels mit einem Metallfilm zur Reduzierung einer Auswirkung von möglichen Fehlern,
- Fig. 3b: einen Querschnitt eines Ausführungsbeispiels entsprechend der gestrichelten Schnittlinie des piezoelektrisch angetriebenen MEMS-Spiegelscanners nach Fig. 3a,
- Fig. 3c: eine Draufsicht auf eine Federstruktur eines piezoelektrisch angetriebenen MEMS-Spiegelscanners eines weiteren Ausführungsbeispiels ohne einen Metallfilm zur Reduzierung einer Auswirkung von möglichen Fehlern,
- Fig. 3d: einen Querschnitt eines Ausführungsbeispiels entsprechend der gestrichelten Schnittlinie des piezoelektrisch angetriebenen MEMS-Spiegelscanners nach Fig. 3c,
- Fig. 4: eine Draufsicht auf die Federstruktur eines piezoelektrisch angetriebenen MEMS-Spiegelscanners mit bevorzugten Anbringungsstellen piezoelektrischer Elemente,
- Fig. 5a: einen Querschnitt eines Ausführungsbeispiels des piezoelektrisch angetriebenen MEMS-Spiegelscanners mit einem Metallfilm im Bereich eines piezoelektrischen Elements mit einer dielektrischen Schicht,
- Fig. 5b: einen Querschnitt eines Ausführungsbeispiels des piezoelektrisch angetriebenen MEMS-Spiegelscanners mit einem Metallfilm im Bereich eines piezoelektrischen Elements mit einer zu Fig. 5a dünneren dielektrischen Schicht,
- Fig. 5c: einen Querschnitt eines Ausführungsbeispiels des piezoelektrisch angetriebenen MEMS-Spiegelscanners mit einem Metallfilm im Bereich eines piezoelektrischen Elements mit einer dielektrischen Schicht, die zum Öffnungsbereich hin abnimmt,
- Fig. 5d: einen Querschnitt eines weiteren Ausführungsbeispiels des piezoelektrisch angetriebenen MEMS-Spiegelscanners ohne einen Metallfilm im Bereich eines piezoelektrischen Elements mit einer dielektrischen Schicht,
- Fig. 5e: einen Querschnitt eines weiteren Ausführungsbeispiels des piezoelektrisch angetriebenen MEMS-Spiegelscanners ohne einen Metallfilm im Bereich eines piezoelektrischen Elements mit einer zu Fig. 5d dünneren dielektrischen Schicht,
- Fig. 5f: einen Querschnitt eines weiteren Ausführungsbeispiels des piezoelektrisch angetriebenen MEMS-Spiegelscanners ohne einen Metallfilm im Bereich eines piezoelektrischen Elements mit einer dielektrischen Schicht, die zum Öffnungsbereich hin abnimmt,
- Fig. 6a: einen Querschnitt einer weiteren Ausführungsform eines piezoelektrisch angetriebenen MEMS-Spiegelscanners im Bereich eines piezoelektrischen Elements mit einer zusätzlichen Passivierungsschicht,
- Fig. 6b: einen Querschnitt einer weiteren Ausführungsform eines piezoelektrisch angetriebenen MEMS-Spiegelscanners im Bereich eines piezoelektrischen Elements mit einer zusätzlichen Passivierungsschicht und einem leitfähigen Schichtfilm,
- Fig. 6c: einen Querschnitt einer weiteren Ausführungsform eines piezoelektrisch angetriebenen MEMS-Spiegelscanners im Bereich eines piezoelektrischen Elements mit einer zusätzlichen Passivierungsschicht, einem Metallfilm und einem leitfähigen Schichtfilm,
- Fig. 7a: einen Querschnitt einer weiteren Ausführungsform eines piezoelektrisch angetriebenen MEMS-Spiegelscanners mit einem Metallfilm im Bereich eines piezoelektrischen Elements mit ei- ner flächendeckenden dielektrischen Schicht,
- Fig. 7b: einen Querschnitt einer anderen Ausführungsform eines piezoelektrisch angetriebenen MEMS-Spiegelscanners ohne einen Metallfilm im Bereich eines piezoelektrischen Elements mit einer flächendeckenden dielektrischen Schicht,
- Fig. 8a: einen Querschnitt einer weiteren Ausführungsform eines piezoelektrisch angetriebenen MEMS-Spiegelscanners mit einem Metallfilm im Bereich eines piezoelektrischen Elements mit einem gefüllten Öffnungsbereich einer dielektrischen Schicht,
- Fig. 8b: einen Querschnitt einer weiteren Ausführungsform eines piezoelektrisch angetriebenen MEMS-Spiegelscanners ohne Metallfilm im Bereich eines piezoelektrischen Elements mit einem gefüllten Öffnungsbereich einer dielektrischen Schicht,
- Fig. 9: einen Querschnitt einer weiteren Ausführungsform eines piezoelektrisch angetriebenen MEMS-Spiegelscanners, wobei ein leitfähiger Schichtfilm als ein oberer Metallkontakt und eine Spiegelschicht verwendet wird,
- Fig. 10: einen Querschnitt einer anderen Ausführungsform eines piezoelektrisch angetriebenen MEMS-Spiegelscanners, wobei ein leitfähiger Schichtfilm und ein Metallfilm als ein oberer Metallkontakt und der leitfähige Schichtfilm als eine Spiegelschicht verwendet wird,
- Fig. 11a: eine Herstellungsabfolge für einen piezoelektrisch angetriebenen MEMS-Spiegelscanners entsprechend Fig. 1b,
- Fig. 11b: eine Herstellungsabfolge für einen piezoelektrisch angetriebenen MEMS-Spiegelscanners mit einem Metallfilm.

Wiederkehrende und ähnliche Merkmale verschiedener Ausführungsformen sind in den Figuren mit identischen oder ähnlichen alphanumerischen Bezugszeichen versehen.

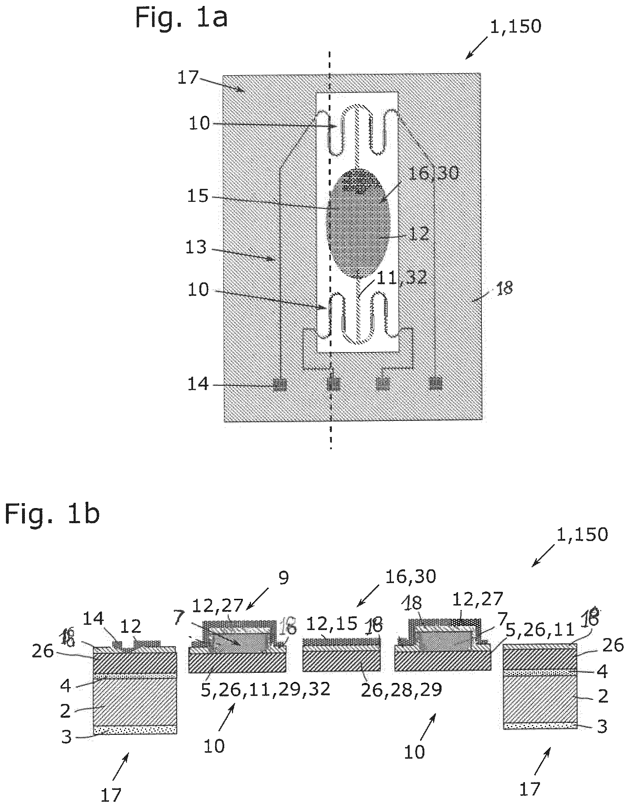

Fig. 1a zeigt eine Draufsicht und Fig. 1b eine Querschnittsansicht eines Ausführungsbeispiels eines mikromechanischen Bauteils 1, das als ein piezoelektrisch angetriebener MEMS-Spiegelscanner 150 ausgebildet ist. In der Draufsicht ist ein vereinfachtes Layout des piezoelektrisch angetriebenen MEMS-Spiegelscanners 150 mit seinen Funktionsbereichen dargestellt. Ein Auslenkungselement 16, das insbesondere als eine Spiegelplatte 30 ausgebildet ist, weist eine Trägerschicht 28 und eine lichtreflektierende Spiegelschicht 15 auf. Die Spiegelplatte 30 ist mit einer Aufhängung 32 - ausgebildet als eine Federstruktur 11 - mechanisch verbunden und aufgehängt. Die Federstruktur 11 ist an einer als Chiprahmen ausgebildete Halterung 17 aufgehängt. Sowohl die Spiegelplatte 30 als auch die Federstruktur 11 sind durch Freistellungen in dem MEMS-Spiegelscanner 150 definiert. Die Federstruktur 11 ist zumindest teilweise mit einer piezoelektrischen Schicht 7, insbesondere piezoelektrischen Elementen 10 bedeckt, um einen Antriebs- und/oder Erfassungsbereich zu erzeugen. Es ist mindestens ein Erfassungs- und/oder ein Antriebsbereich definiert. Zusätzlich kann ein Teil der Halterung 17 mit der piezoelektrischen Schicht 7 bedeckt sein. Dadurch können Stufen im Bereich der Halterung 17 minimiert werden, um niederohmige Verbindungen zu vermeiden. Um eine elektrische Spannung an die piezoelektrische Schicht 7 anzulegen, sind metallische Bondpads 14 und elektrische Verdrahtungsleitungen 13 auf Basis eines leitfähigen Schichtfilms 12 vorgesehen. In einem mit Piezobereich bezeichneten Bereich 9 der piezoelektrischen Elemente 10 bildet der leitfähige Schichtfilm 12 eine zweite Elektrode 27 für die piezoelektrischen Elemente 10. Elektrisch getrennt davon kontaktiert der leitfähige Schichtfilm 12 zusätzlich eine leitfähige Halbleiterschicht 26, hierbei insbesondere ausgebildet als polykristalline Siliziumschicht 29, die im Bereich 9 der piezoelektrischen Elemente 10 erste Elektroden 5 für die piezoelektrischen Elemente 10 bilden. Die Siliziumschicht 29 kann jedoch auch aus einem einkristallinem Silizium gebildet sein.

Ferner bildet der leitfähige Schichtfilm 12 die lichtreflektierende Spiegelschicht 15 der Spiegelplatte 30.

Um eine Ablenkung eines eintreffenden Lichtstrahles zu erzielen, wird eine elektrische Spannung an die metallischen Bondpads 14 angelegt. Eine angelegte elektrische Spannung an die Bondpads 14 führt über die erste Elektrode 5 und die zweite Elektrode 27 zu einer piezoelektrischen Verformung der piezoelektrischen Schicht 7 und einer Betätigung des piezoelektrischen Elements 10. Die Verformung der piezoelektrischen Schicht 7 des piezoelektrischen Elements 10 bewirkt eine Auslenkung der Federstruktur 11. Die polykristalline Siliziumschicht 29 der Federstruktur 11 bildet zugleich die Trägerschicht 28 der Spiegelplatte 30 des MEMS-Spiegelscanners 150. Auf diese Weise ist die Spiegelplatte 30 mechanisch mit der Federstruktur 11 gekoppelt und eine Auslenkung der Federstruktur 11 führt zu einer Auslenkung der Spiegelplatte 30. Abhängig von der Federstruktur 11 kann sich die Spiegelplatte 30 in einer oder zwei Achsen drehen, wodurch ein Lichtstrahl eindimensional oder zweidimensional gesteuert und/oder erfasst wird. Ein mechanisches Verhalten des MEMS-Spiegelscanners wird zum einen durch die Schichtdicken und zum anderen durch die mittels des Tiefenätzens erzeugten Freistellungen definiert.

Fig. 1b zeigt einen Querschnitt der Fig. 1a, um die Funktionsbereiche des piezoelektrisch angetriebenen MEMS-Spiegelscanners 150 zu erläutern.

Die der Spiegelplatte 30 umgebene Halterung 17, die vorliegend als Chip-Rahmen ausgebildet, weist im Querschnitt, eine untere Passivierungsschicht 3, ein Siliziumsubstrat 2, eine Zwischenpassivierungsschicht 4, die polykristalline Siliziumschicht 29 und eine obere Passivierungsschicht 18 auf. Es kann vorgesehen sein, dass der MEMS-Spiegelscanner 150 keine untere Passivierungsschicht 3 aufweist. Die obere Passivierungsschicht 18 dient als elektrischer Isolator und überdeckt im Piezobereich 9 die piezoelektrische Schicht 7, die direkt auf der polykristallinen Siliziumschicht 29 (leitfähigen Halbleiterschicht 26) angeordnet ist. Das Siliziumsubstrat 2 ist eingerichtet, die Halterung 17 beziehungsweise den Chip-Rahmen formstabil zu halten.

Die piezoelektrischen Elemente 10 weisen einen Schichtaufbau, von einer Seite des Siliziumsubtrat 2 ausgehend, aus polykristalliner Siliziumschicht 29 , piezoelektrischer Schicht 7, oberer Passivierungsschicht 18 und den zumindest teilweise bedeckenden und/oder partiell geöffneten weiteren leitfähigen Schichtfilm 12 auf. Die polykristalline Siliziumschicht 29 dient im Piezobereich 9 als erste Elektrode 5 für eine Ansteuerung der piezoelektrischen Elemente 10 und/oder zu einer Erfassung eines Auslenkungszustandes der Federstruktur 11 und/oder der Spiegelplatte 30. Ferner ist die polykristalline Siliziumschicht 29 bzw. leitfähige Halbleiterschicht 26 eingerichtet zusätzlich die Federstruktur 11 des MEMS-Spiegelscanners 150 zu bilden.

Um eine elastische Verformung der Federstruktur 11 zu ermöglichen, umfasst ein Schichtaufbau der Federstruktur 11, von einer Seite des Siliziumsubtrat 2 ausgehend, die polykristalline Siliziumschicht 29 und die obere Passivierungsschicht 18. Ferner kann es vorgesehen sein, dass die Federstruktur 11 unterhalb der polykristallinen Siliziumschicht 29 die Zwischenpassivierungsschicht 4 aufweist.

Die Spiegelplatte 30 weist einen Schichtaufbau, von einer Seite des Siliziumsubtrat 2 ausgehend, aus polykristalliner Siliziumschicht 29, oberer Passivierungsschicht 18 (die im Bereich der Spiegelplatte 30 jedoch auch weggelassen werden kann) und leitfähigem Schichtfilm 12 auf. Bei der Spiegelplatte 30 dient die polykristalline Siliziumschicht 29 als eine Trägerschicht 28 und der leitfähige Schichtfilm 12 dient als die lichtreflektierende Spiegelschicht 15. In anderen Ausführungsformen kann es vorgesehen sein, dass die piezoelektrischen Elemente 10 und die Spiegelplatte 30 unterhalb der polykristallinen Siliziumschicht 29 die Zwischenpassivierungsschicht 4 aufweist.

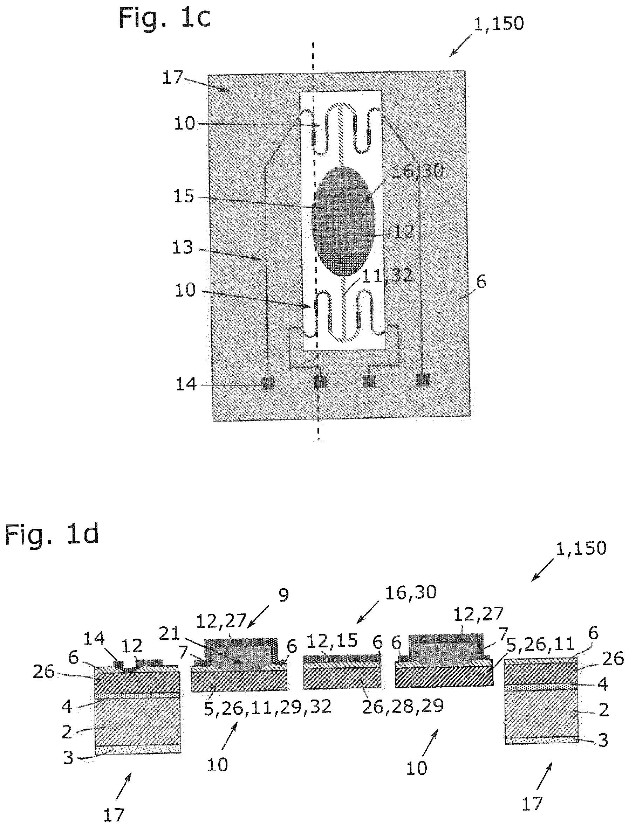

Fig. 1c zeigt eine Draufsicht und Fig. 1d eine Querschnittsansicht eines weiteren Ausführungsbeispiels eines piezoelektrisch angetriebenen MEMS-Spiegelscanners 150. Das Ausführungsbeispiel auf Fig. 1c und Fig. 1d ist identisch zu dem Ausführungsbeispiel aus Fig. 1a und Fig. 1b, jedoch ist hierbei ein Metallfilm 8 vorgesehen, der die piezoelektrische Schicht 7 bedeckt. Es kann vorgesehen sein, dass der Metallfilm 8 eingerichtet ist, als eine Maskierungsschicht für einen weiteren Strukturierungsprozess, insbesondere zum Maskieren der piezoelektrischen Elemente 10, zu dienen. Wird der Metallfilm 8 weggelassen, kann eine Opferschicht als Maskierung für den weiteren Strukturierungsprozess verwendet werden, die anschließend entfernt wird und womit das Ausführungsbeispiel von Fig. 1a und Fig. 1b realisiert werden kann.

Weiterhin ist hier auf der leitfähigen Halbleiterschicht 26 bzw. der polykristallinen Siliziumschicht 29 eine dielektrische Schicht 6 angeordnet, die im Piezobereich 9 teilweise zur leitfähigen Halbleiterschicht teilweise geöffnet ist.

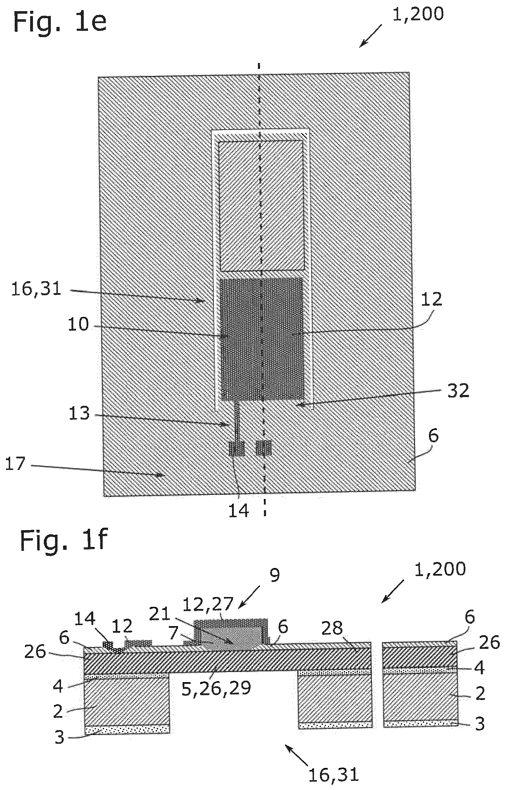

Fig. 1e zeigt eine Draufsicht und Fig. 1f eine Querschnittsansicht eines weiteren Ausführungsbeispiels eines mikromechanischen Bauteils 1, das als ein Energie-Harvester 200 ausgebildet ist. In der Draufsicht ist ein vereinfachtes Layout des Energie-Harvester dargestellt. Ein Auslenkungselement 16, ausgebildet als ein Balkenelement 31, ist mit einer Aufhängung 32 mechanisch verbunden und die Aufhängung 32 ist an einer als Chiprahmen ausgebildeten Halterung 17 befestigt. Das Balkenelement 31 ist zumindest teilweise mit einer piezoelektrischen Schicht 7, insbesondere einem piezoelektrischen Element 10 bedeckt, um einen Erfassungsbereich zu erzeugen. Selbstverständlich kann auch eine Vielzahl von piezoelektrischen Elementen 10 auf dem Balkenelement 31 vorgesehen sein. Es ist mindestens ein Erfassungsbereich definiert. Zusätzlich kann ein Teil der Halterung 17 mit der piezoelektrischen Schicht 7 bedeckt sein. Dadurch können Stufen im Bereich der Halterung 17 minimiert werden, um niederohmige Verbindungen zu vermeiden.

Sowohl das Balkenelement 31 als auch die Aufhängung 32 sind durch Freistellungen in dem Energie-Harvester 200 definiert. Durch die Freistellungen kann das Balkenelement 31 über die Aufhängung 32 mittels Schwingungen und/oder Vibrationen, insbesondere Umgebungsvibrationen in Auslenkung versetzt werden. Eine Empfindlichkeit gegenüber verschiedenen Frequenzspektren und/oder Frequenzbanden kann mittels einer Geometrie des Energie-Harvester 200, insbesondere einer räumlichen Geometrie des Balkenelementes 31, der Aufhängung 32 und der Halterung 17 eingestellt werden. Die Schwingungen und/oder Vibrationen werden von dem piezoelektrischen Element 10, das sich auf dem Balkenelement 31 befindet, in eine elektrische Spannung umgewandelt, wobei insbesondere eine Kristallgitterverzerrung von Elementarzellen der piezoelektrischen Schicht 7 durch den piezoelektrischen Effekt genutzt wird. Diese elektrische Spannung wird über metallische Bondpads 14 und metallische elektrische Verdrahtungsleitungen 13 abgegriffen und kann durch eine geeignete Schaltung, insbesondere aus Kondensatoren und Widerständen, gespeichert und/oder verwendet werden. Der leitfähige Schichtfilm 12 bedeckt zumindest teilweise die piezoelektrische Schicht 7. Im Bereich 9 des piezoelektrischen Elementes 10 bildet der leitfähige Schichtfilm 12 die zweite Elektrode 27 für das piezoelektrische Elemente 10. Elektrisch getrennt davon kontaktiert der leitfähige Schichtfilm 12 zusätzlich die leitfähige polykristalline Siliziumschicht 29 , die im Bereich 9 des piezoelektrischen Elementes 10 die erste Elektrode 5 für das piezoelektrische Element 10 bildet.

Fig. 1f zeigt einen Querschnitt der Fig. 1e, um die Funktionsbereiche des Energie-Harvesters 200 zu erläutern.

Die den Energie-Harvester 200 umgebene Halterung 17 weist im Querschnitt eine untere Passivierungsschicht 3, ein Siliziumsubstrat 2, eine obere Passivierungsschicht 4, eine polykristalline Siliziumschicht 29 und eine dielektrische Schicht 6 auf. Die dielektrische Schicht 6 ist bereichsweise geöffnet, um einen direkten Schichtkontakt zwischen dem leitfähigen Schichtfilm 12 und der polykristallinen Siliziumschicht 29 zu ermöglichen. Analog zu oben, dient die dielektrische Schicht 6 als elektrischer Isolator um niederohmige Verbindungen zu verhindern. Das Siliziumsubstrat 2 ist eingerichtet, die Halterung 17 des Energie-Harvester 200 formstabil zu halten. Die polykristalline Siliziumschicht 29 dient im Bereich 9 als erste Elektrode 5 für die piezoelektrischen Elemente 10. Auch hier kann die gezeigte dielektrische Schicht durch eine obere Passivierungsschicht, ähnlich der Schicht 18 aus Fig. 1b ersetzt werden, wobei sie im Piezobereich 9 die zweite Elektrode 27 überdeckt, und die piezoelektrische Schicht 7 kontaktiert dann die polykristalline Siliziumschicht 29.

Das piezoelektrische Element 10 weist die polykristalline Siliziumschicht 29, gegebenenfalls zumindest teilweise die dielektrische Schicht 6, die piezoelektrische Schicht 7 und einen zumindest teilweise bedeckenden weiteren leitfähigen Schichtfilm 12, gegebenenfalls auch die obere Passivierungsschicht auf. Die polykristalline Siliziumschicht 29 bildet - analog zum MEMS-Spiegelscanner 150 - hierbei sowohl die erste Elektrode 5 als auch die Aufhängung 32.

Das Balkenelement 31 umfasst einen Schichtaufbau bestehend aus einer unteren Passivierungsschicht 3, einem Siliziumsubstrat 2, einer Zwischenpassivierungsschicht 4, einer polykristallinen Siliziumschicht 29 und einer dielektrischen Schicht 6 bzw. einer oberen Passivierungsschicht. Das Siliziumsubstrat 2 ist dabei eingerichtet als eine Schwungmasse für das Balkenelement 31 zu dienen. Auf diese Weise kann eine träge Masse des Balkenelementes 31 erhöht werden, um die Umgebungsvibrationen vorteilhaft in eine Schwingung, Vibration und/oder Auslenkung des Balkenelementes 31 umzuwandeln. Insbesondere kann eine Empfindlichkeit gegenüber verschiedenen Frequenzspektren der Umgebungsvibration mittels eines Gewichtes der Schwungmasse eingestellt werden. Zumindest in einer Umgebung des Bereiches 9 des piezoelektrischen Elementes 10 besitzt das Balkenelement 31 jedoch keine untere Passivierungsschicht 3, kein Siliziumsubstrat 2 und keine Zwischenpassivierungsschicht 4, um eine elastische Verformung der piezoelektrischen Schicht 7 zu ermöglichen.

Wie bereits oben eingeführt, zeigt Fig. 2a einen Ausschnitt eines piezoelektrischen Elements eines piezoelektrisch angetriebenen MEMS-Spiegelscanners 100 nach dem Stand der Technik mit einer oberen Passivierung 4, einer polykristallinen Siliziumschicht 29, einer herkömmlichen metallischen ersten Elektrode 20, einer piezoelektrischen Schicht 7 und einer zweiten Elektrode 27 und vergleichend Fig. 2b einen piezoelektrisch angetriebenen MEMS-Spiegelscanner 150 mit einer ersten Elektrode 5 aus polykristallinem Silizium gemäß einer Ausführungsform der vorliegenden Erfindung. Im Vergleich zu Fig. 2a wird in Fig. 2b auf eine erste metallische Elektrode 20 verzichtet. Aufgrund einer hohen Leitfähigkeit von polykristallinem Silizium, insbesondere dotiertem polykristallinem Silizium, ist eine Erhöhung der Betriebsspannung des piezoelektrisch angetriebenen MEMS-Spiegelscanners 150 im Vergleich zu der in Fig. 2a gezeigten herkömmlichen Ausführungsform nur gering. Der Verzicht auf die metallische erste Elektrode 20 kann die Komplexität sowie die Kosten der Herstellung des piezoelektrisch angetriebenen MEMS-Spiegelscanners reduzieren.

Besitzt die piezoelektrische Schicht 7 jedoch direkten Kontakt zu der polykristallinen Siliziumschicht 29, wie in Fig. 2c gezeigt, führt dies zu elektrischen niederohmigen Verbindungen, insbesondere an Stufenkanten eines Öffnungsbereiches 21 der dielektrischen Schicht 6. Gründe für die niederohmigen Verbindungen sind Fehlstellen und/oder Kristalldefekten 19 aufgrund eines schlechten Wachstumsverhaltens im Öffnungsbereich 21 und/oder durch Materialermüdung aufgrund hoher Belastung im Betrieb. Im Nachfolgenden werden Ausführungsformen beschrieben, wie niederohmige Verbindungen verhindert werden können.

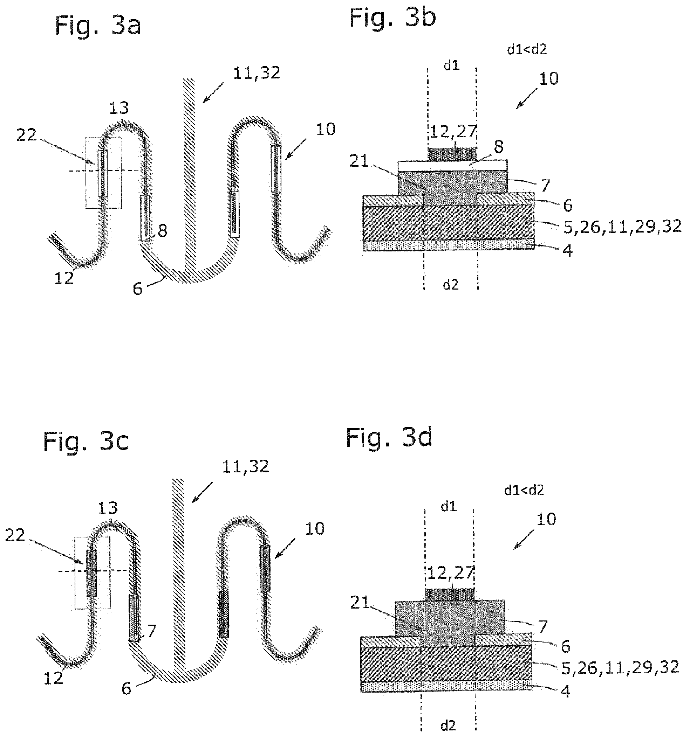

Fig. 3a zeigt analog zu Fig. 1a eine Draufsicht der Federstruktur 11. Die Draufsicht in Fig. 3a zeigt gebogene Bereiche der Federstruktur 11 mit einem kleinen Krümmungsradius und relativ gerade Bereiche der Federstruktur 11 mit einem großen Krümmungsradius. In bevorzugter Ausführung besitzen verschiedene Bereiche der Federstruktur 11 unterschiedliche Krümmungen, insbesondere Rechtskrümmungen und Linkskrümmungen. Die Federstruktur 11 ist über einen geradlinigen Bereich der Federstruktur 11 mit der Spiegelplatte 30 mechanisch verbunden.

Die piezoelektrischen Elemente 10 befinden sich an Positionen auf der Federstruktur 11 mit einer geringen Krümmung - insbesondere eine geringe Krümmung außerhalb einer zu der Substratebene parallelen Ebene - während einer Auslenkung der Federstruktur 11. Die Positionen auf der Federstruktur 11 mit einer geringen Krümmung während der Auslenkung der Federstruktur sind dadurch gekennzeichnet, dass sie in einem Betrieb beziehungsweise einer Auslenkung der Federstruktur 11 eine geringe Verformung aufweisen. Basierend auf Simulationen, beispielsweise mechanische Finite-Elemente-Analyse kann ein Bereich der Federstruktur 11 mit einer großen Krümmung im Betrieb identifiziert werden. Diese Bereiche sollten keine piezoelektrischen Elemente 10 enthalten, um niederohmige Verbindungen aufgrund von Materialermüdung zu verhindern.

Weiterhin sollten sich die piezoelektrischen Elemente 10 an Positionen mit einem optimalen Spannungsverhalten, insbesondere an Positionen mit einer hohen positiven oder hohen negativ mechanischen Spannung befinden. Auf diese Weise kann die Betätigungs- und/oder Erfassungseffizienz maximiert werden.

Fig. 3b zeigt eine Querschnittsansicht eines piezoelektrischen Elements 10 eines MEMS-Spiegelscanners 150. Eine gepunktete Linie in Fig. 3a repräsentiert eine Querschnittsfläche von Fig. 3b. Die Ausführungsform in Fig. 3b ähneln der Ausführungsform des piezoelektrischen Elements aus Fig. 1d, jedoch ist eine Breite d1 der zweiten Elektrode 27 kleiner als eine Öffnung d2 der dielektrischen Schicht 6. Die Öffnung d2 der dielektrischen Schicht definiert dabei eine Breite der ersten Elektrode 5. Fehlstellen und/oder Kristalldefekte innerhalb der piezoelektrischen Schicht 7 entstehen vermehrt in einem Randbereich des Öffnungsbereiches 21, insbesondere an Stufenkanten der dielektrischen Schicht 6. Die Fehlstellen und/oder Kristalldefekte setzen sich typischerweise in einer zu einer Siliziumsubstratebene senkrechten Richtung fort. Dadurch, dass die Breite d1 der zweiten Elektrode 27 und damit die Fläche der zweiten Elektrode 27 kleiner ist als eine Öffnung d2 und damit die Öffnungsfläche der dielektrischen Schicht 6, liegt die zweite Elektrode 27 nicht direkt über dem Randbereich des Öffnungsbereiches der ersten Elektrode 5. Auf diese Weise kann ein Eindringen des leitfähigen Schichtfilms 12 der zweiten Elektrode 27 in die Fehlstellen verhindert werden. Das Eindringen des leitfähigen Schichtfilms 12 der zweiten Elektrode 27 in Fehlstellen kann wiederum zu unerwünschten niederohmigen Verbindungen führen.

Fig. 3c zeigt eine zu Fig. 3a analoge Draufsicht und Fig. 3d eine zu Fig. 3b analoge Querschnittsansicht von Fig. 3c. Entsprechend zu Fig. 1c und Fig. 1d wurde jedoch in Fig. 3c und Fig. 3d auf den Metallfilm 8 verzichtet.

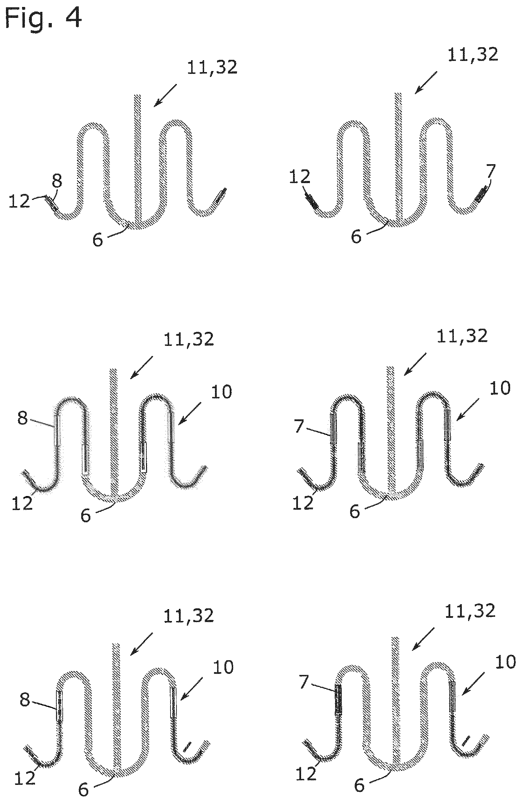

Fig. 4 zeigt analog zu Fig. 3a und Fig. 3c Draufsichten der Federstrukturen 11 mit (links) und ohne (rechts) Metallfilm 8 eines piezoelektrisch angetriebenen MEMS-Spiegelscanners 150. Dabei zeigt Fig. 4 insbesondere weitere vorteilhafte Positionen der piezoelektrischen Elemente 10 auf der Federstruktur 11. Die vorteilhaften Positionen können hierbei beispielsweise (wie bereits oben ausgeführt) durch Simulationen, insbesondere mechanische Finite-Elemente-Analyse bestimmt werden.

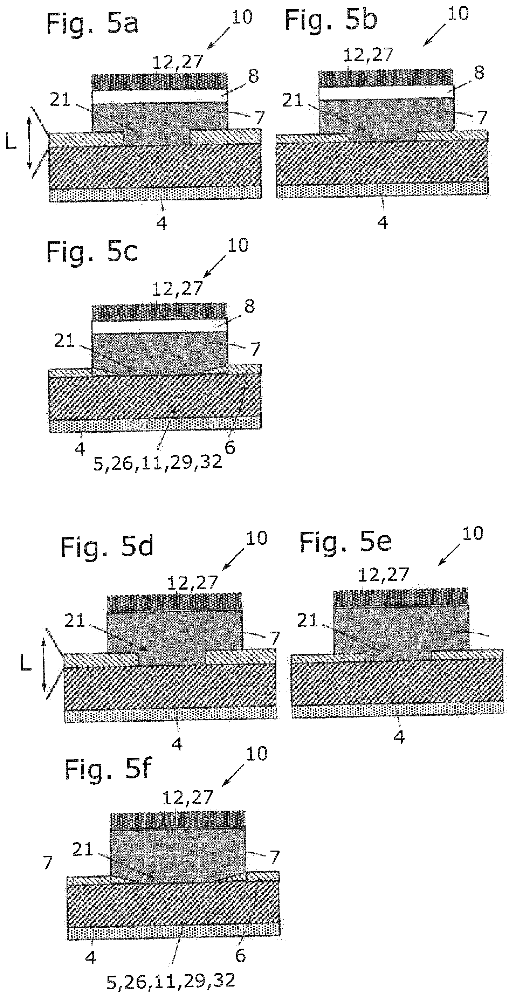

Falls, wie in Fig. 5a (sowie analog in Fig. 5d, jedoch ohne Metallfilm 8) gezeigt, die Breite der zweiten Elektrode 27 jedoch größer ist als die Öffnung der dielektrischen Schicht 6, müssen Kristalldefekte an den Stufenkanten der Öffnung der dielektrischen Schicht 6 unterdrückt werden. Ein Kristalldefekt könnte in dieser Ausführungsform zu einer elektrischen niederohmigen Verbindung führen. Ein Verringern einer Stufenhöhe L, wie in Fig. 5b (sowie analog in Fig. 5e, jedoch ohne Metallfilm 8) gezeigt, auf Basis einer sehr dünnen dielektrischen Schicht 6, beispielsweise 10 nm Al₂O₃ kann zu einer geringeren Defektdichte beziehungsweise eine geringere räumliche Ausprägung der Kristalldefekte an den Stufenkanten der dielektrischen Schicht 6 führen. Dies minimiert daher die Wahrscheinlichkeit, dass Metall, insbesondere der leitfähige Schichtfilm 12 in die Fehlstellen und/oder Kristalldefekte eindringt, was zu niederohmigen Verbindungen zwischen der zweiten Elektrode 27 und der ersten Elektrode 5 führen würde. Wie in Fig. 5c (sowie analog in Fig. 5f, jedoch ohne Metallfilm 8) gezeigt und auch in Fig. 1d zu erkennen ist, kann die Stufenhöhe L auch minimiert werden, indem die Schichtdicke der dielektrischen Schicht 6 zu dem Öffnungsbereich 21 hin abnimmt. Insbesondere kann eine lineare oder quasilineare Abnahme der Schichtdicke der dielektrischen Schicht 6 zu einer verschwindenden Schichtdicke vorgesehen sein. Eine Abnahme der Schichtdicke der dielektrischen Schicht 6 kann unter anderem durch lithografische Strukturierungsprozesse realisiert werden.

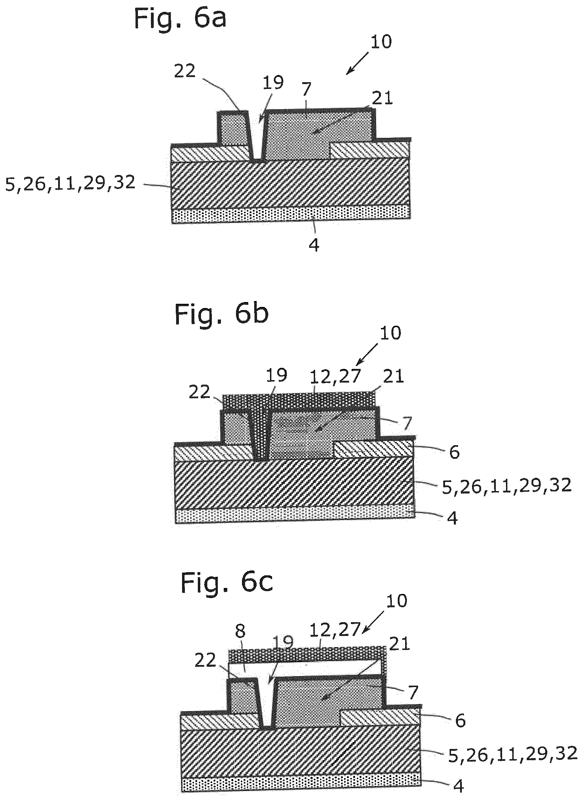

Um niederohmige Verbindungen zu verhindern, kann eine weitere Ausführungsform vorgesehen sein. Fig. 6a, 6b und 6c zeigt eine zur Fig. 5a ähnliche Ausführungsform, in der jedoch zusätzlich eine obere Passivierungsschicht 22, beispielsweise Al₂O₃, die piezoelektrische Schicht 7 bedeckt. Ist, wie in Fig. 6b gezeigt, die obere Passivierungsschicht 22 mit dem leitfähigen Schichtfilm 12 bedeckt, so dient die Passivierungsschicht 22 als eine elektrische Isolationsbarriere. Hierdurch kann ein galvanischer Kontakt, trotz eines Vorhandenseins eines Kristalldefektes 19 verhindert werden. Fig. 6c zeigt eine zu Fig. 6b analog Ausführungsform, bei der jedoch zusätzlich ein Metallfilm 8 verwendet wird und bei dieser Ausführungsform Material von dem Metallfilm 8 in den Kristalldefekt 19 eindringt.

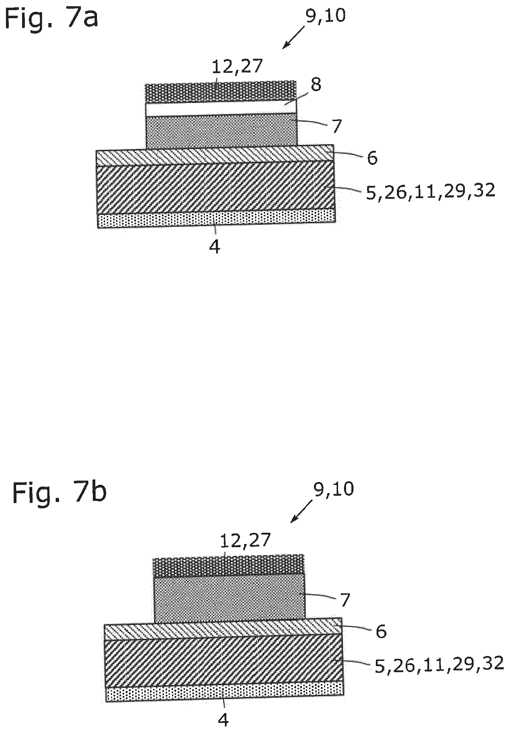

Weitere Möglichkeiten, Stufenkanten der dielektrischen Schicht zu verhindern, ist den Öffnungsbereich 21 zu füllen oder auf eine Öffnung der dielektrischen Schicht 6 zu verzichten. In Fig. 7a (sowie analog in Fig. 7b, jedoch ohne Metallfilm 8) ist, zumindest im Bereich 9 der piezoelektrischen Elemente 10, die polykristalline Siliziumschicht 29 flächendeckend mit der dielektrischen Schicht 6 bedeckt, beispielsweise mit SiO₂. Damit weist die dielektrische Schicht 6 zur polykristallinen Siliziumschicht 29 keine Öffnung auf. Somit tritt keine Stufe auf und die piezoelektrische Schicht 7 kann unter optimalen Planaritätsbedingungen wachsen. Auf diese Weise können Fehlstellen und/oder Kristalldefekte unterdrückt werden.

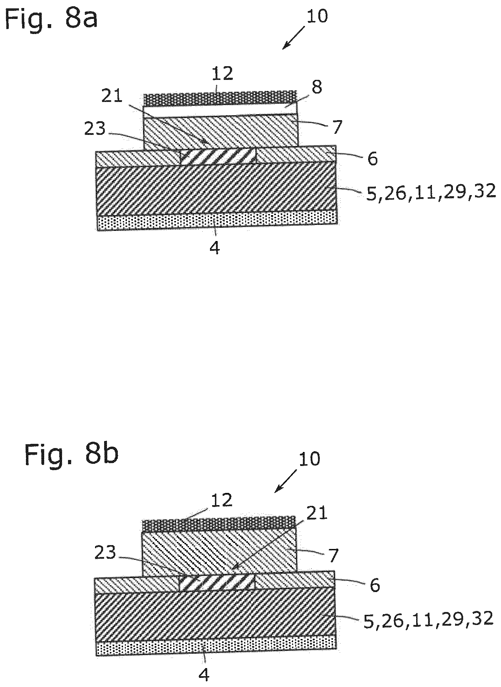

Fig. 8a (sowie analog Fig. 8b, jedoch ohne Metallfilm 8) zeigt, dass in einer anderen Ausführungsform polykristallines Silizium 23 im Öffnungsbereich 21 der dielektrischen Schicht 6 abgeschieden oder gezüchtet ist und zu einer Planarisierung führt. Das polykristalline Silizium 23 im Öffnungsbereich 21 kann insbesondere durch selektives Wachstum und/oder eine Maskierung realisiert werden. Ein anderer Ansatz, das polykristalline Silizium 23 im Öffnungsbereich 21 zu realisieren, kann das Wachstum von Silizium auf Basis eines Epitaxieprozesses und einem anschließenden selektiven, chemischen und mechanischen Polierprozess für eine Planarisierung sein. Aufgrund der Planarisierung kann eine Entstehung einer Fehlstelle und/oder eines Kristalldefektes verhindert werden, dass die Wahrscheinlichkeit einer niederohmigen Verbindung reduziert.

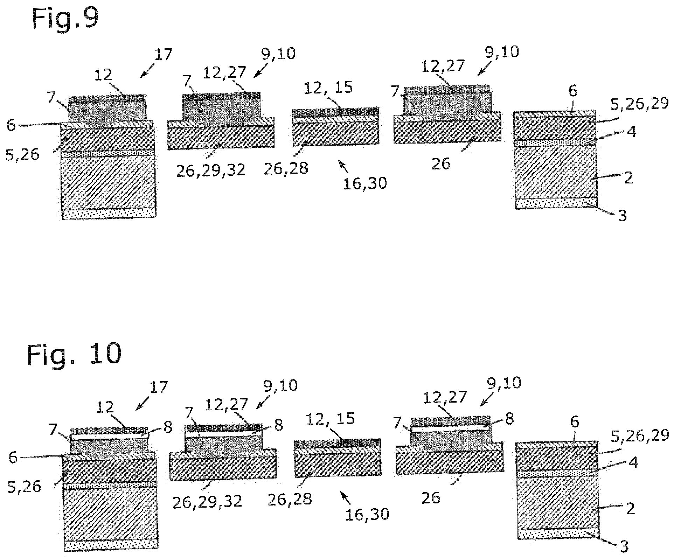

Alternativ zu den oben beschriebenen Ausführungsformen kann, wie in Fig. 9 gezeigt, vorgesehen sein, dass die piezoelektrische Schicht 7 gegenüber der Ausführungsform von Fig. 1d verbreitert ist und die Halterung 17 zumindest bereichsweise abdeckt. Dadurch können Stufen, insbesondere Stufen des leitfähigen Schichtfilms 12 im Bereich der Halterung 17 minimiert werden, um niederohmige Verbindungen zu vermeiden. Eine Strukturierung und/oder Maskierung der piezoelektrischen Schicht 7 in Fig. 9 kann durch eine Opferschicht erreicht werden, die anschließend entfernt wird. Eine weitere Ausführungsform mit einer verlängerten piezoelektrischen Schicht 7, die die Halterung 17 zumindest bereichsweise abdeckt, zeigt Fig. 10. Hierbei wird der Metallfilm 8 als eine Maske für den anschließenden Strukturierungsprozess der piezoelektrischen Schicht 7 verwendet.

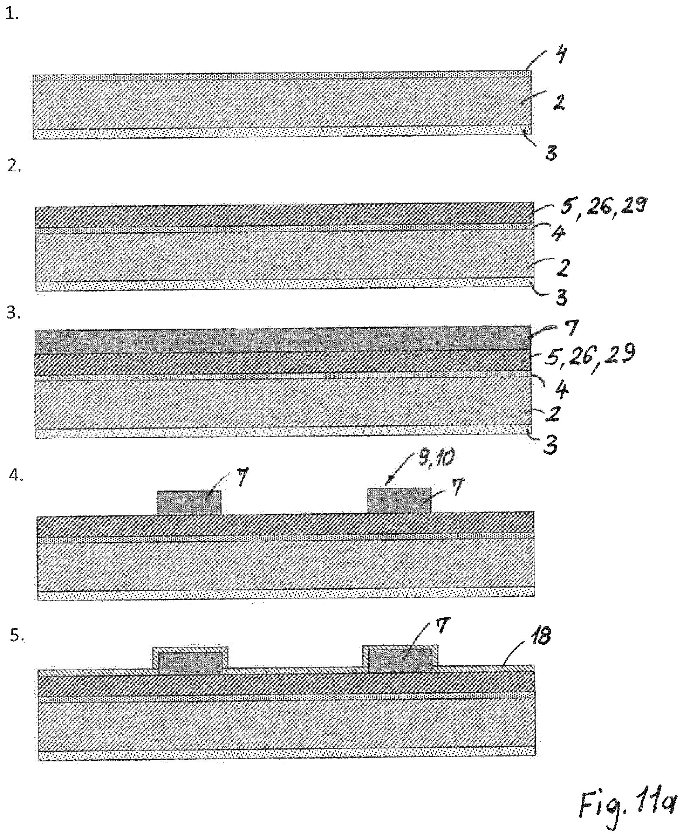

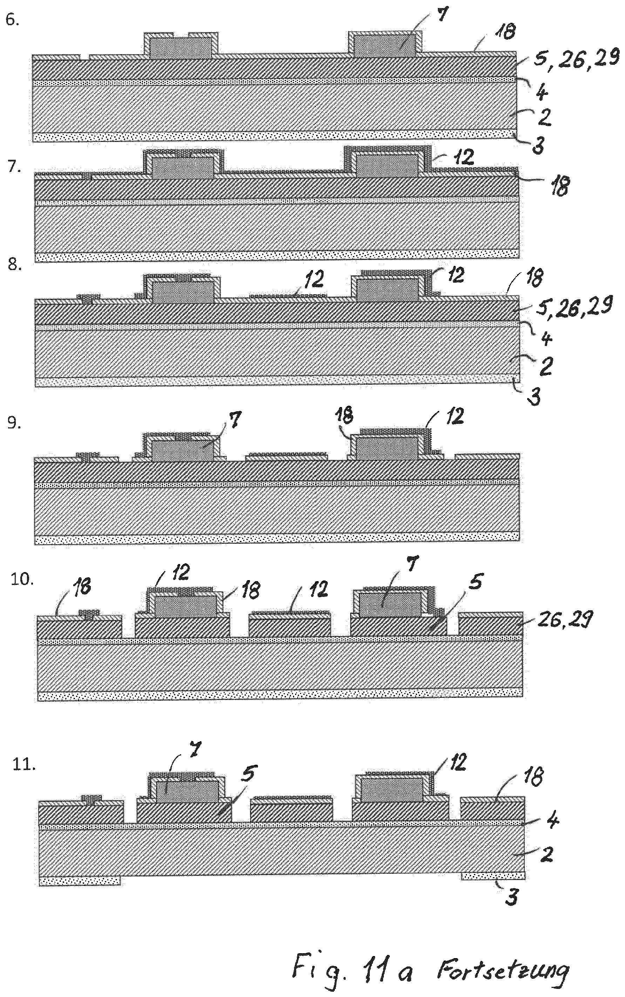

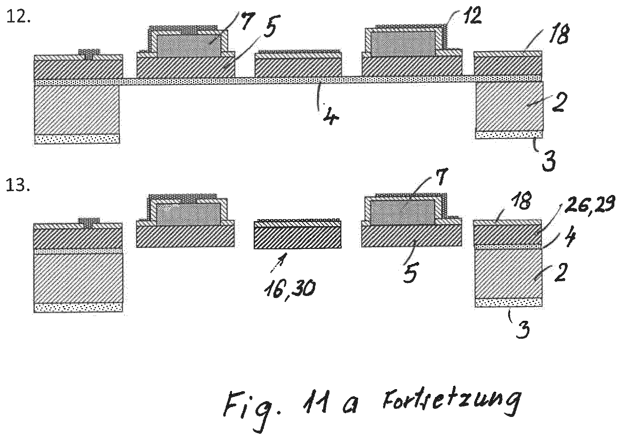

Fig. 11a zeigt eine beispielhafte Herstellungsabfolge eines piezoelektrisch angetrieben MEMS-Spiegelscanners 150.

In einem ersten Schritt 1 wird ein Siliziumsubstrat 2, insbesondere ein kristallines Bulk-Siliziumsubstrat, passiviert. Eine untere Passivierungsschicht 3 und eine Zwischenpassivierungsschicht 4 werden durch Nass- und/oder Trockenoxidation hergestellt.

In einem zweiten Schritt 2 wird dotiertes polykristallines Silizium auf die Zwischenpassivierungsschicht 4 abgeschieden. Der Abscheidungsprozess erfolgt beispielsweise in einer Epitaxie-Abscheideanlage. Die entstandene polykristalline Siliziumschicht 29 besitzt typischerweise Schichtdicken zwischen 1 µm und 300 µm.

Alternativ können bei Verwendung von einkristallinem Silizium sogenannte konventionell erwerbliche SOI Wafer verwendet werden und somit den Schritt 2 ersetzen. Bei diesem Prozess wird auf die zuvor aufgebrachte Oxidschicht ein weiterer kristalliner Siliziumwafer aufgebondet und auf eine beliebige Schichtdicke zurückgeschliffen.

Anschließend erfolgt im Schritt 3 eine Abscheidung, insbesondere eine physikalische Gasphasenabscheidung (physical vapour deposition, PVD), einer piezoelektrischen Schicht 7. Die piezoelektrische Schicht 7 sollte hierbei hohe piezoelektrische und/oder pyroelektrische und/oder ferroelektrische Konstanten aufweisen. Insbesondere eignen sich hierfür keramische Ferroelektrika oder Piezoelektrika, wie beispielsweise Aluminiumnitrid (AlN) oder Bleizirkonat-Titanat (PZT). Jedoch eignen sich auch teilkristalline Polymerwerkstoff wie PVDF (Polyvinylidenfluorid (CF2-CH2)n).

In einem vierten Schritt 4 wird in einem Plasma und/oder nasschemischen Prozess die piezoelektrische Schicht 7 strukturiert. Die piezoelektrische Schicht 7 kann nassgeätzt - beispielsweise durch Phosphorsäure für AlN - oder trockengeätzt werden. Eine Fotolithographiemaske dient dabei für die Strukturierung der piezoelektrischen Schicht 7. Die Piezobereiche 9 definieren die piezoelektrischen Elemente 10 und einen Antriebs- und/oder Erfassungsbereich des MEMS-Spiegelscanners 150.

In Schritt 5 wird eine Passivierungsschicht 18 über die strukturierte piezoelektrische Schicht 7 und die polykristalline Siliziumschicht 29 abgeschieden, wobei die Passivierungsschicht in einem anschließenden Schritt 6 strukturiert wird, wie beispielhaft auch im Bereich eines Piezobereichs 9 dargestellt ist. Als Passivierungsschicht kann PECVD SiO2 verwendet werden, jedoch können jegliche Materialien verwendet werden, welche elektrisch nicht leitfähig sind und zudem eine relativ hohe Durchschlagsfestigkeit haben, beispielweise Siliziumnitrid Si3N4, Al2O3 Aluminiumoxid.

In einem Schritt 7 wird der leitfähige Schichtfilm 12, insbesondere aus Aluminium, aber auch andere Materialien, wie Cu, Mo u.a. bestehend, auf die strukturierte Passivierungsschicht 18 abgeschieden.

In einem Schritt 8 wird der der leitfähige Schichtfilm 12 über eine Fotolithografiemaske unter Verwendung von Trockenätzen, beispielsweise Plasmaätzen auf Chlorbasis oder Nassätzen auf Phosphorsäurebasis strukturiert. Der leitfähige Schichtfilm 12 bildet die Verdrahtungsleitungen 13, die Bondpads 14 und gegebenenfalls eine lichtreflektierende Spiegelschicht 15. Die Fotolithografiemaske wird mit einem Plasma oder nasschemischen Verfahren anschließend entfernt.

Gegebenenfalls kann es möglich sein, einen weiteren Prozessschritt einzuführen um die Reflexionseigenschaften im Bereich der Spiegelplatte zu erhöhen, beispielsweise durch einen weiteren Metallisierungs- und Strukturierungsschritt.

In einem Schritt 9 wird die obere Passivierungsschicht 18 durch Trockenätzung, insbesondere Plasmaätzen auf Fluorbasis unter Verwendung einer Fotolithografiemaske strukturiert.

In einem Schritt 10 wird unter der Verwendung der Fotolithografiemaske aus Schritt 9 tiefes reaktives Ionenätzen (DRIE) für eine Strukturierung der polykristallinen Siliziumschicht 29 verwendet. In einer anderen Ausführungsform kann die Zwischenpassivierungsschicht 4 zusätzlich in einem selben Schritt oder in einem zusätzlichen Prozessschritt zumindest teilweise geöffnet werden. Die Fotolithografiemaske wird anschließend mit einem Plasma oder nasschemischen Verfahren entfernt. In diesem Schritt wird die mechanische Federstruktur 11 und die Spiegelplatte 30 definiert.

In einem Schritt 11 wird die untere Passivierungsschicht 3 mit einem Trockenätzverfahren, insbesondere Plasmaätzen auf Fluorbasis über eine Fotolithografiemaske bereichsweise geöffnet.

In einem Schritt 12 wird die aus Schritt 11 vorhandene oder eine neue Fotolithografiemaske für tiefes reaktives Ionenätzen verwendet, um das Siliziumsubstrat 2 zu strukturieren.

In einem Schritt 13 wird schließlich die Zwischenpassivierungsschicht 4 bereichsweise entfernt. Die damit erzielten Freistellungen definieren die Halterung 17, die Spiegelplatte 30 und die Federstruktur 11. Nach einem letzten Plasma oder nasschemischen Fotolack-Entfernungsschritt ist die Herstellung des piezoelektrisch angetriebenen MEMS-Spiegelscanners 150 abgeschlossen.

Gegebenenfalls kann in Schritt 11 die untere Passivierungsschicht 3 vollständig entfernt werden.

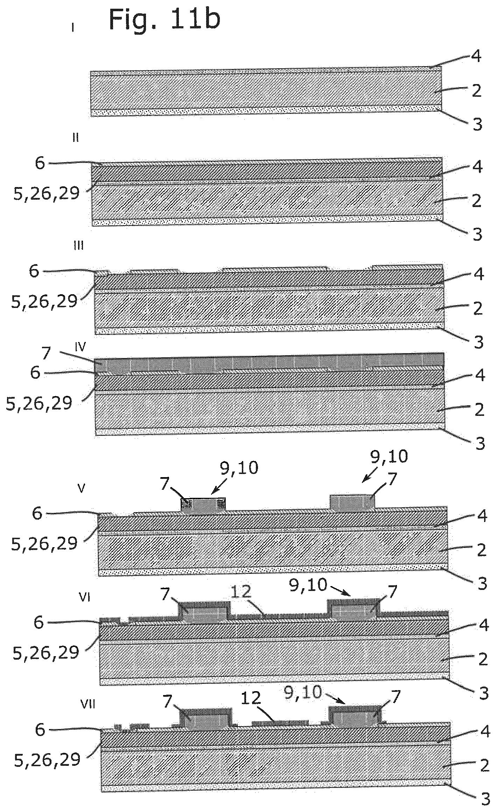

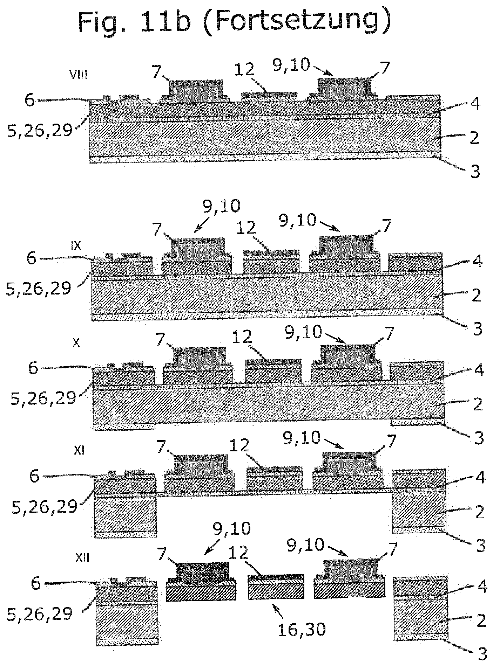

Fig. 11b zeigt ein weiteres Ausführungsbeispiel.

Schritt I entspricht Schritt 1 aus Fig. 11a.

In einem zweiten Schritt II wird entsprechend Schritt 2 aus Fig. 11a dotiertes polykristallines Silizium auf die Passivierungsschicht 4 abgeschieden. Anschließend wird eine weitere Passivierung der polykristallinen Siliziumschicht 29 für die Bildung einer dielektrischen Schicht 6 durchgeführt. Die dielektrische Schicht 6 kann beispielsweise aus der Gasphase in Form von Siliziumdioxid aufgebracht werden. Auch hier kann, wie zu Fig. 11a beschrieben, ein SOI Wafer verwendet werden.

In einem dritten Schritt III wird zunächst die dielektrische Schicht 6 unter Verwendung einer Fotolithografiemaske und eines Ätzprozesses, insbesondere Plasmaätzen auf Fluorbasis und/oder Nassätzen, insbesondere mit Flusssäure, bereichsweise geöffnet. Die Fotolithografiemaske wird durch ein Plasma und/oder nasschemisch entfernt. Anschließend erfolgt eine Abscheidung, insbesondere eine physikalische Gasphasenabscheidung (physical vapour deposition, PVD), einer piezoelektrischen Schicht 7. Die piezoelektrische Schicht 7 sollte hierbei hohe piezoelektrische und/oder pyroelektrische und/oder ferroelektrische Konstanten aufweisen. Insbesondere eignen sich hierfür keramische Ferroelektrika oder Piezoelektrika, wie beispielsweise Aluminiumnitrid (AlN) oder Bleizirkonat-Titanat (PZT). Jedoch eignen sich auch teilkristalline Polymerwerkstoff wie PVDF (Polyvinylidenfluorid (CF2-CH2)n). Ein Metallfilm 8 wird auf die piezoelektrischen Schicht 7 abgeschieden und ist metallisch ausgebildet. Insbesondere kann mittels physikalischer Gasphasenabscheidung abgeschiedenes Molybdän als Metallfilm 8 vorgesehen sein. In einer anderen Ausführungsform kann es jedoch auch vorgesehen sein, dass ein HalbleiterMaterial, wie beispielsweise polykristallines Silizium anstelle des Metallfilms 8 verwendet wird.

In einem vierten Schritt IV wird der Metallfilm 8 über eine Fotolithografiemaske und einer Verwendung eines Ätzprozesses strukturiert. Falls der Metallfilm 8 aus Molybdän besteht wird ein Nassätzprozess auf Phosphorsäurebasis verwendet.

In einem fünften Schritt V wird, wie im Schritt 3 der Fig. 11a, die piezoelektrische Schicht 7 strukturiert. Allerdings dient der Metallfilm 8 dabei als eine Hartmaske für die Strukturierung der piezoelektrischen Schicht 7.

Der Schritt VI entspricht Schritt 7 der Fig. 11a und Schritt Vii dem Schritt 8 der Fig. 11a

In einem achten Schritt VIII wird die dielektrische Schicht 6 durch Trockenätzung, insbesondere Plasmaätzen auf Fluorbasis unter Verwendung einer Fotolithografiemaske strukturiert.

Schritt IX entspricht Schritt 10 aus Fig. 11a, wobei hier die Fotolithografiemaske aus Schritt VIII verwendet wird.

Die Schritte X, XI und XII entsprechen den Schritten 11 12 und 13 der Fig. 11a.

Falls kein Metallfilm 8 verwendet wird, wird im Schritt IV anstelle des Metallfilms 8 eine Opferschicht oder Hilfsschicht auf die piezoelektrische Schicht 7 aufgebracht. Diese Opferschicht oder Hilfsschicht dient als eine Maskierung für einen Strukturierungsprozess der piezoelektrischen Schicht 7. Diese Opferschicht oder Hilfsschicht wird nach dem Strukturierungsprozess wieder entfernt und kann zum Beispiel Photoresist entsprechen.

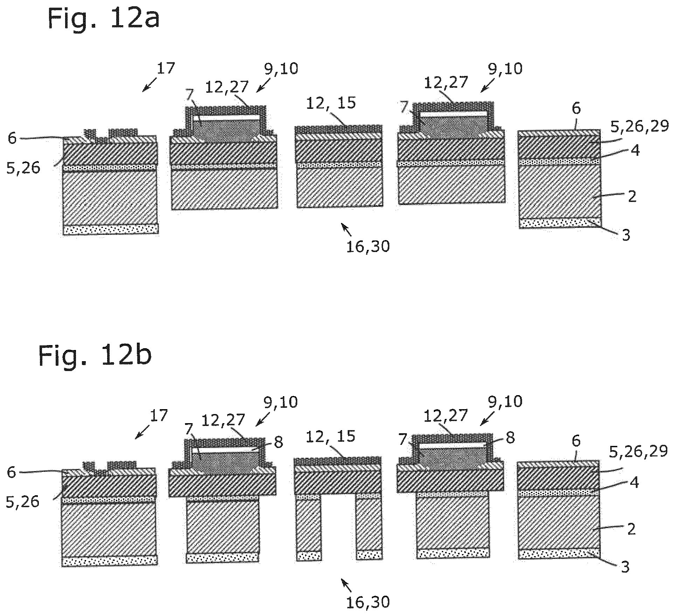

Figuren 12a und 12b zeigen eine alternative Ausführungsform zu Fig. 1d. In diesen Ausführungsformen wird zumindest teilweise das Siliziumsubstrat 2 unterhalb der polykristallinen Siliziumschicht 29 im Bereich des Auslenkungselementes 16 und der Piezobereiche 9 stehen gelassen. Dadurch lässt sich eine Versteifung des Auslenkungselementes 16 erzielen, das sich auf eine dynamische Deformation des Auslenkungselementes 16 auswirken kann. Insbesondere kann dies zu einer geringeren Deformation des Auslenkungselementes 16 führen. Verschiedene Strukturen des Siliziumsubstrat 2, insbesondere wabenartige Strukturen, können vorgesehen sein. Ferner kann eine gesamte Schichtdicke des Auslenkungselementes 16 variiert werden, um insbesondere eine Resonanzfrequenz des mikromechanischen Bauteils damit zu variieren.

**Liste der Bezugszeichen:**

| | |
|---|---|
| 1 | Mikromechanisches Bauteil |
| 2 | Siliziumsubstrat |
| 3 | untere Passivierungsschicht |
| 4 | Zwischenpassivierungsschicht |
| 5 | erste Elektrode |
| 6 | dielektrische Schicht |
| 7 | piezoelektrische Schicht |
| 8 | Metallfilm |
| 9 | Piezobereiche |
| 10 | piezoelektrisches Element |
| 11 | Federstruktur |
| 12 | leitfähiger Schichtfilm |
| 13 | metallische elektrische Verdrahtungsleitungen |
| 14 | Bondpads |
| 15 | lichtreflektierende Spiegelschicht |
| 16 | Auslenkungselement |
| 17 | Halterung |
| 18 | obere Passivierungsschicht |
| 19 | Kristalldefekt |
| 20 | herkömmliche metallische erste Elektrode |
| 21 | Öffnungsbereich |
| 22 | Passivierungsschicht |
| 23 | polykristallines Silizium |
| 26 | leitfähige Halbleiterschicht |
| 27 | zweite Elektrode |
| 28 | Trägerschicht |
| 29 | polykristalline Siliziumschicht |
| 30 | Spiegelplatte |
| 31 | Balkenelement |
| 32 | Aufhängung |
| 100 | herkömmlicher piezoelektrisch angetriebener MEMS-Spiegelscanner |
| 150 | MEMS-Spiegelscanner |
| 200 | Energie-Harvester |

## Patentansprüche

1. Mikromechanisches Bauteil (1) mit einem Schichtaufbau und mindestens einem piezoelektrischen Element (10), enthaltend eine erste Elektrode (5) und zweite Elektrode (27) zur Erzeugung und/oder Erfassung von Auslenkungen eines Auslenkungselementes (16), das mit einer Halterung (17) verbunden ist, wobei der Schichtaufbau ein Siliziumsubstrat (2), eine leitfähige Halbleiterschicht (26), eine piezoelektrische Schicht (7) und einen leitfähigen Schichtfilm (12) aufweist,
**dadurch gekennzeichnet, dass**
die leitfähige Halbleiterschicht (26) die erste Elektrode (5) und der leitfähige Schichtfilm (12) die zweite Elektrode (27) des piezoelektrischen Elementes bilden und dass die leitfähige Halbleiterschicht (26) gleichzeitig eine Trägerschicht (28) für das Auslenkungselement (16) bildet.

2. Mikromechanisches Bauteil (1) nach Anspruch 1, **dadurch gekennzeichnet, dass** die leitfähige Halbleiterschicht (26), die piezoelektrische Schicht (7) und der leitfähige Schichtfilm (12) schichtweise in unterschiedlichen Schichtebenen ausgebildet sind, wobei sie eine von einer Seite des Siliziumsubstrates (2) ausgehende Schichtreihenfolge folgender Art aufweisen:
• leitfähige Halbleiterschicht (26),
• piezoelektrische Schicht (7),
• leitfähiger Schichtfilm (12),
wobei jeweils zwischen den Schichten weitere Halbleiter-, Isolator- und/oder Metallschichten eingefügt sein können.

3. Mikromechanisches Bauteil (1) nach einem der Ansprüche 1 oder 2, **dadurch gekennzeichnet, dass** das Auslenkungselement (16) eine mit der Halterung (17) verbundene Federstruktur (11) und eine an der Federstruktur (11) aufgehängte Spiegelplatte (30) ist, wobei die leitfähige Halbleiterschicht (26) gleichzeitig die Trägerschicht (28) der Spiegelplatte und/oder der Federstruktur bildet, und optional **dadurch gekennzeichnet, dass** der leitfähige Schichtfilm (12) auch eine lichtreflektierende Spiegelschicht (15) der Spiegelplatte (30) bildet.

4. Mikromechanisches Bauteil (1) nach Anspruch 3, **dadurch gekennzeichnet, dass** die Federstruktur (11) zumindest bereichsweise die leitfähige Halbleiterschicht (26), die piezoelektrische Schicht (7) und den leitfähigen Schichtfilm (12) aufweist, und optional **dadurch gekennzeichnet, dass** die leitfähige Halbleiterschicht (26), die piezoelektrische Schicht (7) und der leitfähige Schichtfilm (12) der Federstruktur (11) sich an Positionen mit kleinen Biegeradien bei einer Auslenkung aus einer Ebene zu einer Ruhelage der Federstruktur (11) befinden.

5. Mikromechanisches Bauteil (1) nach einem der Ansprüche 1 oder 2, **dadurch gekennzeichnet, dass** das Auslenkungselement (16) als ein mindestens einseitig aufgehängtes Balkenelement (31) ausgebildet ist, wobei die leitfähige Halbleiterschicht (26) gleichzeitig die Trägerschicht (28) des Balkenelements (31) bildet, und optional **dadurch gekennzeichnet, dass** das Balkenelement (31) zumindest bereichsweise die leitfähige Halbleiterschicht (26), die piezoelektrische Schicht (7) und den leitfähigen Schichtfilm (12) aufweist, und/oder dass das Balkenelement (31) zumindest bereichsweise das Siliziumsubstrat (2) aufweist, das derart angeordnet ist, dass es eine Schwungmasse für das Balkenelement (31) bildet.

6. Mikromechanisches Bauteil (1) nach einem der Ansprüche 1 bis 5, **dadurch gekennzeichnet, dass** eine Passivierungsschicht (18, 22) auf der piezoelektrischen Schicht (7) mindestens teilweise angeordnet ist und/oder **dadurch gekennzeichnet, dass** die piezoelektrische Schicht (7) auf der leitfähigen Halbleiterschicht (26) angeordnet ist.

7. Mikromechanisches Bauteil (1) nach einem der Ansprüche 1 bis 6, **dadurch gekennzeichnet, dass** zwischen der leitfähigen Halbleiterschicht (26) und der piezoelektrischen Schicht (7) zumindest bereichsweise eine dielektrische Schicht (6) liegt.

8. Mikromechanisches Bauteil (1) nach Anspruch 7, **dadurch gekennzeichnet, dass** die leitfähige Halbleiterschicht (26) von der piezoelektrischen Schicht (7) durch eine dielektrische Schicht (6) getrennt ist, wobei die dielektrische Schicht (6) flächendeckend oder bereichsweise mit einem Öffnungsbereich (21) zu der Halbleiterschicht (26) ausgebildet ist.

9. Mikromechanisches Bauteil (1) nach Anspruch 8, **dadurch gekennzeichnet, dass** der Öffnungsbereich (21) der dielektrischen Schicht (6) mit Silizium gefüllt ist.

10. Mikromechanisches Bauteil (1) nach einem der Ansprüche 1 bis 9, **dadurch gekennzeichnet, dass** die leitfähige Halbleiterschicht (26) aus Silizium, insbesondere polykristallinem Silizium besteht, und/oder **dadurch gekennzeichnet, dass** zwischen der piezoelektrischen Schicht (7) und dem leitfähigen Schichtfilm (12), zumindest bereichsweise ein Metallfilm (8) angeordnet ist, und/oder **dadurch gekennzeichnet, dass** die Halterung (17) ein Chip-Rahmen des mikromechanischen Bauteils (1) ist, und/oder **dadurch gekennzeichnet, dass** auf die von dem leitfähigen Schichtfilm (12) gebildete zweite Elektrode (27) eine dielektrische Schicht zu ihrer Stabilisierung aufgebracht ist.

11. Verfahren zur Herstellung eines mikromechanischen Bauteils (1), das folgende Schritte aufweist:
• Abscheiden einer leitfähigen Halbleiterschicht (26) auf einem Siliziumsubstrat (2);
• Abscheiden einer piezoelektrischen Schicht (7);
• Abscheiden eines als zweite Elektrode (27) dienenden leitfähigen Schichtfilms (12) auf die piezoelektrische Schicht (7) und
• Strukturieren eines Auslenkungselementes (16) durch einen Maskierungsprozess des Substrates (2), der leitfähigen Halbleiterschicht (26), der piezoelektrischen Schicht (7) und des leitfähigen Schichtfilms (12) durch lithografische Prozesse
**dadurch gekennzeichnet, dass**
die leitfähige Halbleiterschicht (26) als eine erste Elektrode (5) für die piezoelektrische Schicht (7) und gleichzeitig als eine Trägerschicht (28) für das Auslenkungselement (16) verwendet wird.

12. Verfahren zur Herstellung eines mikromechanischen Bauteils (1) nach Anspruch 11, **dadurch gekennzeichnet, dass** nach dem Abscheiden der piezoelektrischen Schicht (7) ein Abscheiden eines Metallfilms (8) auf die piezoelektrische Schicht (7) folgt.

13. Verfahren zur Herstellung eines mikromechanischen Bauteils (1) nach Anspruch 12, **dadurch gekennzeichnet, dass** der Metallfilm (8) als eine Maskierung für einen späteren Strukturierungsprozess verwendet wird.

14. Verfahren zur Herstellung eines mikromechanischen Bauteils (1) nach Anspruch 11, **dadurch gekennzeichnet, dass** nach dem Abscheiden der piezoelektrischen Schicht (7) eine Hilfs- oder Opferschicht auf die piezoelektrische Schicht (7) abgeschieden wird, die als eine Maskierung für einen späteren Strukturierungsprozess verwendet wird, und optional **dadurch gekennzeichnet, dass** die Hilfs- oder Opferschicht als eine Hartmaske aus SiN ausgebildet wird.

15. Verfahren zur Herstellung eines mikromechanischen Bauteils (1) nach einem der Ansprüche 11 bis 14, **dadurch gekennzeichnet, dass** nach dem Abscheiden der piezoelektrischen Schicht (7) eine Passivierungsschicht (18, 22) auf die piezoelektrischen Schicht (7) abgeschieden wird, und/oder **dadurch gekennzeichnet, dass** das Siliziumsubstrat (2) als ein oxidiertes Siliziumsubstrat ausgebildet wird, und/oder **dadurch gekennzeichnet, dass** der Maskierungsprozess des Substrates (2) derart durchgeführt wird, dass das Substrat (2) zumindest teilweise in einem Bereich des Auslenkungselementes (16) stehen bleibt.

## Claims

1. A micromechanical component (1) having a layered structure and at least one piezoelectric element (10) comprising a first electrode (5) and a second electrode (27) for generating and/or detecting deflections of a deflection element (16), which is connected to a holder (17), wherein the layered structure comprises a silicon substrate (2), a conductive semiconductor layer (26), a piezoelectric layer (7) and a conductive layer film (12),
**characterised in that**
the conductive semiconductor layer (26) forms the first electrode (5) and the conductive layer film (12) forms the second electrode (27) of the piezoelectric element, and **in that** the conductive semiconductor layer (26) at the same time forms a carrier layer (28) for the deflection element (16).

2. The micromechanical component (1) according to claim 1, **characterized in that** the conductive semiconductor layer (26), the piezoelectric layer (7) and the conductive layer film (12) are formed in layers in different layer planes, wherein they have a layer sequence of the following type starting from one side of the silicon substrate (2):
• conductive semiconductor layer (26),
• piezoelectric layer (7),
• conductive layer film (12),
wherein further semiconductor layers, insulator layers and/or metal layers may be inserted between the layers.

3. The micromechanical component (1) according to any one of claims 1 or 2, **characterized in that** the deflection element (16) is a spring structure (11) connected to the holder (17) and a mirror plate (30) suspended from the spring structure (11), wherein the conductive semiconductor layer (26) simultaneously forms the carrier layer (28) of the mirror plate and/or the spring structure, and optionally **characterized in that** the conductive layer film (12) also forms a light-reflecting mirror layer (15) or the mirror plate (30).

4. The micromechanical component (1) according to claim 3, **characterized in that** the spring structure (11) comprises the conductive semiconductor layer (26), the piezoelectric layer (7) and the conductive layer film (12) at least in some areas, and optionally **characterized in that** the conductive semiconductor layer (26), the piezoelectric layer (7) and the conductive layer film (12) of the spring structure (11) are located at positions with small bending radii when the spring structure (11) is deflected from a plane to a rest position.

5. The micromechanical component (1) according to any one of claims 1 or 2, **characterized in that** the deflection element (16) is formed as a beam element (31) suspended on at least one side, wherein the conductive semiconductor layer (26) at the same time forms the carrier layer (28) of the beam element (31), and optionally **characterized in that** the beam element (31) comprises the conductive semiconductor layer (26), the piezoelectric layer (7) and the conductive layer film (12) at least in some areas, and/or that the that the beam element (31) comprises the silicon substrate (2) at least in some regions, the latter being arranged in such a way that it forms an inertial mass for the beam element (31).

6. The micromechanical component (1) according to any one of claims 1 to 5, **characterized in that** a passivation layer (18, 22) is arranged at least partially on the piezoelectric layer (7), and/or **characterized in that** the piezoelectric layer (7) is arranged on the conductive semiconductor layer (26).

7. The micromechanical component (1) according to any one of claims 1 to 6, **characterized in that** a dielectric layer (6) is arranged between the conductive semiconductor layer (26) and the piezoelectric layer (7), at least in some areas.

8. The micromechanical component (1) according to claim 7, **characterized in that** the conductive semiconductor layer (26) is separated from the piezoelectric layer (7) by a dielectric layer (6), wherein the dielectric layer (6) is formed with full coverage or in regions with an opening area (21) to the semiconductor layer (26).

9. The micromechanical component (1) according to claim 8, **characterized in that** the opening region (21) of the dielectric layer (6) is filled with silicon.

10. The micromechanical component (1) according to any one of claims 1 to 9, **characterized in that** the conductive semiconductor layer (26) consists of silicon, in particular polycrystalline silicon, and/or **characterized in that** a metal film (8) is arranged between the piezoelectric layer (7) and the conductive layer film (12), at least in some areas, and/or **characterized in that** the holder (17) is a chip frame of the micromechanical component (1), and/or **characterized in that**, for stabilization, a dielectric layer is applied to the second electrode (27) formed by the conductive layer film (12).

11. A method for producing a micromechanical component (1), said method having the following steps:
• depositing a conductive semiconductor layer (26) on a silicon substrate (2);
• depositing a piezoelectric layer (7);
• depositing a conductive layer film (12), serving as second electrode (27), on the piezoelectric layer (7); and
• structuring a deflection element (16) by a masking process of the substrate (2), of the conductive semiconductor layer (26), the piezoelectric layer (7) and the conductive layer film (12) by lithographic processes,
**characterised in that**
the conductive semiconductor layer (26) is used as a first electrode (5) for the piezoelectric layer (7) and at the same time as a carrier layer (28) for the deflection element (16).

12. The method for producing a micromechanical component (1) according to claim 11, **characterized in that** a metal film (8) is deposited on the piezoelectric layer (7) after the piezoelectric layer (7) has been deposited.

13. The method for producing a micromechanical component (1) according to claim 12, **characterized in that** the metal film (8) is used as a masking for a later structuring process.

14. The method for producing a micromechanical component (1) according to claim 11, **characterized in that** an auxiliary or sacrificial layer is deposited on the piezoelectric layer (7) after the piezoelectric layer (7) has been deposited and is used as a masking for a later structuring process, and optionally **characterized in that** the auxiliary or sacrificial layer is formed as a hard mask of SiN.

15. The method for producing a micromechanical component (1) according to any one of claims 11 to 14, **characterized in that** a passivation layer (18, 22) is deposited on the piezoelectric layer (7) after the piezoelectric layer (7) has been deposited, and/or **characterized in that** the silicon substrate (2) is formed as an oxidized silicon substrate, and/or **characterized in that** the masking process of the substrate (2) is performed in such a way that the substrate (2) remains at least partially in a region of the deflection element (16).

## Revendications

1. Composant micromécanique (1) avec une structure en couches et au moins un élément piézoélectrique (10), comprenant une première électrode (5) et une seconde électrode (27) pour générer et/ou détecter des déflexions d'un élément à déflexion (16) relié à un support (17), dans lequel la structure en couches présente un substrat en silicium (2), une couche semi-conductrice (26) conductrice, une couche piézoélectrique (7) et un film conducteur (12),
**caractérisé en ce que**
la couche semi-conductrice (26) conductrice forme la première électrode (5) et le film conducteur (12) forme la seconde électrode (27) de l'élément piézoélectrique et **en ce que** la couche semi-conductrice (26) conductrice forme simultanément une couche de support (28) pour l'élément à déflexion (16).

2. Composant micromécanique (1) selon la revendication 1, **caractérisé en ce que** la couche semi-conductrice (26) conductrice, la couche piézoélectrique (7) et le film conducteur (12) sont réalisés couche par couche dans différents plans de couche, en présentant une séquence de couches commençant d'un côté du substrat de silicium (2) de la manière ci-dessous :
• une couche semi-conductrice (26) conductrice,
• une couche piézoélectrique (7),
• un film conducteur (12),
dans lequel des couches supplémentaires de semi-conducteur, d'isolant et/ou de métal peuvent être respectivement insérées entre les couches.

3. Composant micromécanique (1) selon l'une quelconque des revendications 1 ou 2, **caractérisé en ce que** l'élément à déflexion (16) est une structure à ressort (11) reliée au support (17) et une plaque miroir (30) accrochée à la structure à ressort (11), dans lequel la couche semi-conductrice (26) conductrice forme simultanément la couche de support (28) de la plaque miroir et/ou de la structure à ressort, et, de manière optionnelle, **caractérisé en ce que** le film conducteur (12) forme également une couche miroir (15), réfléchissant la lumière, de la plaque miroir (30).

4. Composant micromécanique (1) selon la revendication 3, **caractérisé en ce que** la structure à ressort (11) présente au moins localement la couche semi-conductrice (26) conductrice, la couche piézoélectrique (7) et le film conducteur (12), et, de manière optionnelle, **caractérisé en ce que** la couche semi-conductrice (26) conductrice, la couche piézoélectrique (7) et le film conducteur (12) de la structure à ressort (11) sont situés à des positions présentant de petits rayons de courbure pour une déflexion partant d'un plan jusqu'à une position de repos de la structure à ressort (11).

5. Composant micromécanique (1) selon l'une quelconque des revendications 1 ou 2, **caractérisé en ce que** l'élément à déflexion (16) est conçu comme un élément formant poutre (31) accroché au moins d'un côté, dans lequel la couche semi-conductrice (26) conductrice forme simultanément la couche de support (28) de l'élément formant poutre (31), et, de manière optionnelle, **caractérisé en ce que** l'élément formant poutre (31) présente au moins localement la couche semi-conductrice (26) conductrice, la couche piézoélectrique (7) et le film conducteur (12), et/ou **en ce que** l'élément formant poutre (31) présente au moins localement le substrat de silicium (2) qui est agencé de manière à former un volant d'inertie pour l'élément formant poutre (31).

6. Composant micromécanique (1) selon l'une quelconque des revendications 1 à 5, **caractérisé en ce qu'**une couche de passivation (18, 22) est agencée au moins partiellement sur la couche piézoélectrique (7) et/ou **caractérisé en ce que** la couche piézoélectrique (7) est agencée sur la couche semi-conductrice (26) conductrice.

7. Composant micromécanique (1) selon l'une quelconque des revendications 1 à 6, **caractérisé en ce qu'**une couche diélectrique (6) est située au moins localement entre la couche semi-conductrice (26) conductrice et la couche piézoélectrique (7).

8. Composant micromécanique (1) selon la revendication 7, **caractérisé en ce que** la couche semi-conductrice (26) conductrice est séparée de la couche piézoélectrique (7) par une couche diélectrique (6), dans lequel la couche diélectrique (6) est réalisée localement ou sur toute la surface avec une région d'ouverture (21) vers la couche semi-conductrice (26).

9. Composant micromécanique (1) selon la revendication 8, **caractérisé en ce que** la région d'ouverture (21) de la couche diélectrique (6) est remplie de silicium.

10. Composant micromécanique (1) selon l'une quelconque des revendications 1 à 9, **caractérisé en ce que** la couche semi-conductrice (26) conductrice est constituée de silicium, en particulier de silicium polycristallin, et/ou **caractérisé en ce qu'**un film métallique (8) est agencé au moins localement entre la couche piézoélectrique (7) et le film conducteur (12), et/ou **caractérisé en ce que** le support (17) est un châssis de puce du composant micromécanique (1), et/ou **caractérisé en ce qu'**une couche diélectrique est appliquée sur la seconde électrode (27) formée par le film conducteur (12) en vue de sa stabilisation.

11. Procédé de fabrication d'un composant micromécanique (1) présentant les étapes ci-dessous consistant à :
• déposer une couche semi-conductrice (26) conductrice sur un substrat de silicium (2) ;
• déposer une couche piézoélectrique (7) ;
• déposer un film conducteur (12) servant de seconde électrode (27) sur la couche piézoélectrique (7) et
• structurer un élément à déflexion (16) grâce à un procédé de masquage du substrat (2), de la couche semi-conductrice (26) conductrice, de la couche piézoélectrique (7) et du film conducteur (12) par des procédés lithographiques
**caractérisé en ce que**
la couche semi-conductrice (26) conductrice est utilisée comme première électrode (5) pour la couche piézoélectrique (7) et simultanément comme couche de support (28) pour l'élément à déflexion (16).

12. Procédé de fabrication d'un composant micromécanique (1) selon la revendication 11, **caractérisé en ce qu'**un film métallique (8) est déposé sur la couche piézoélectrique (7) après le dépôt de la couche piézoélectrique (7).

13. Procédé de fabrication d'un composant micromécanique (1) selon la revendication 12, **caractérisé en ce que** le film métallique (8) est utilisé comme masque pour un procédé de structuration ultérieur.

14. Procédé de fabrication d'un composant micromécanique (1) selon la revendication 11, **caractérisé en ce qu'**une couche auxiliaire ou sacrificielle utilisée comme masque pour un procédé de structuration ultérieur est déposée sur la couche piézoélectrique (7) après le dépôt de la couche piézoélectrique (7), de manière optionnelle **caractérisé en ce que** la couche auxiliaire ou sacrificielle est réalisée sous la forme d'un masque dur en SiN.

15. Procédé de fabrication d'un composant micromécanique (1) selon l'une quelconque des revendications 11 à 14, **caractérisé en ce qu'**une couche de passivation (18, 22) est déposée sur la couche piézoélectrique (7) après le dépôt de la couche piézoélectrique (7), et/ou **caractérisé en ce que** le substrat de silicium (2) est réalisé sous la forme d'un substrat de silicium oxydé, et/ou **caractérisé en ce que** le procédé de masquage du substrat (2) est mis en œuvre de telle manière que le substrat (2) reste au moins partiellement dans une région de l'élément à déflexion (16).
